# EUROPÄISCHE PATENTSCHRIFT

(11) **EP 2 523 895 B1**
(45) Veröffentlichungstag und Bekanntmachung des Hinweises auf die Patenterteilung: **04.06.2014**
(21) Anmeldenummer: 11700162.8
(22) Anmeldetag: 10.01.2011
(51) Int. Cl.: B81B 3/00

(54) **MIKROELEKTROMECHANISCHES HALBLEITERBAUELEMENT**
MICRO-ELECTROMECHANICAL SEMICONDUCTOR COMPONENT
COMPOSANT SEMI-CONDUCTEUR MICROÉLECTROMÉCANIQUE

(30) Priorität: 11.01.2010 EP 10150405
(43) Veröffentlichungstag der Anmeldung: 21.11.2012
(73) Patentinhaber: ELMOS Semiconductor AG, 44227 Dortmund (DE)
(72) Erfinder: TEN HAVE, Arnd Dr., 44227 Dortmund (DE)
(74) Vertreter: Von Kreisler Selting Werner - Partnerschaft von Patentanwälten und Rechtsanwälten mbB
(86) Internationale Anmeldenummer: PCT/EP2011/050209
(87) Internationale Veröffentlichungsnummer: WO 2011/083158

(56) Entgegenhaltungen:
- US-A- 6 006 607
- US-B1- 6 351 996

## Beschreibung

Die Erfindung betrifft ein mikroelektromechanisches Halbleiterbauelement, das sich insbesondere als Druck- oder Beschleunigungssensor einsetzen lässt. Insbesondere handelt es sich bei der Erfindung um ein CMOS-kompatibles, mikroelektromechanisches Bauelement mit niedrigem Stromverbrauch, hoher Fertigungsgenauigkeit und hoher Präzision.

Die Erfindung betrifft im Allgemeinen ein zu bekannten Halbleiterherstellungsprozessen kompatibles mikroelektromechanisches Bauelement mit niedrigem Stromverbrauch. Eine spezielle beispielhafte Ausprägung ist ein mikromechanischer CMOS-Drucksensor mit niedrigem Stromverbrauch.

Es ist bekannt, für die Realisierung von Druck- bzw. Beschleunigungssensoren auf mikroelektromechanische Strukturen (sogenannte MEMS) zurückzugreifen (siehe z.B. US-B-6 351 996). Derartige Strukturen werden mit Hilfe bekannter Lithografieverfahren und damit im Wesentlichen unter Verwendung der gleichen Herstellungsschritte produziert, wie sie von der Herstellung von integrierten Schaltungen bekannt sind. Dabei wird in einem Halbleitersubstrat eine Kavität ausgebildet, die beispielsweise in einem ersten Halbleiter-Wafer ausgebildet wird. Dieser erste Halbleiter-Wafer wird anschließend mit einem zweiten Halbleiter-Wafer verbondet, so dass die Kavität letztendlich lateral durch Seitenwände in dem ersten Halbleiter-Wafer sowie eine Bodenwand dieses Wafers einerseits und andererseits durch den zweiten Halbleiter-Wafer als Deckwand begrenzt ist. Bei dem Halbleitersubstrat handelt es sich dann um ein Paket von mindestens zwei Halbleiter-Wafern, die miteinander verbondet sind und die mehrere Schichten aus Halbleitermaterial (beispielsweise Silizium bzw. Polysilizium) und zwischen diesen angeordneten Isolationsschichten (beispielsweise SiO) aufweisen. Mechanische Belastungen, die auf eine derartige Struktur einwirken und die es messtechnisch zu erfassen gilt, wirken sich auf eine Verformung, insbesondere Durchbiegung entweder der Deck- oder der Bodenwand der Kavität im Halbleitersubstrat aus. Die betreffende Wand sollte möglichst flexibel an den Bereich des Halbleitersubstrats um die Kavität herum angebunden sein. Zu diesem Zweck ist es bekannt, die betreffende Wand mit insbesondere einseitig eingebrachte Gräben zu verdünnen, wobei zwischen den Gräben Biegestege verbleiben, die den zentralen Bereich der Wand innerhalb der Gräben mit dem Bereich des Halbleitersubstrats um die Kavität herum bei gleichbleibender Dicke der Deck- bzw. Bodenwand verbinden. Innerhalb dieser Biegestege werden dann gegenüber mechanischen Spannungen empfindliche Messelemente (piezoresistive Transistoren, Widerstände o.dgl.) im Halbleitersubstrat ausgebildet, wobei zu diesem Zweck beispielsweise ein CMOS-Prozess verwendet wird.

Drucksensoren der zuvor genannten Art haben sich im Stand der Technik grundsätzlich bewährt. Wünschenswert ist es allerdings, wenn die betreffende druckempfindliche Deck- bzw. Bodenwand der Kavität eine möglichst geringe seismische Sensitivität aufweist.

Aus US-A-6 006 607 ist ein Drucksensor bekannt, der eine über ihren gesamten Bereich flexible Membran aufweist. Zu diesem Zweck weist die Membran, die aus Halbleitermaterial besteht, einseitig eingebrachte Vertiefungen auf. Hierdurch entstehen abschnittsweise dünne Bereiche der Membran, die dieser Flexibilität verleihen, wie es beispielsweise in Fig. 3 der US-A-6 006 607 gezeigt ist.

Aufgabe der Erfindung ist es daher, ein mikroelektromechanisches Halbleiterbauelement zu schaffen, das diesbezüglich von Vorteil ist.

Zur Lösung dieser Aufgabe wird mit der Erfindung ein mikroelektromechanisches Halbleiterbauelement vorgeschlagen, das versehen ist mit den Merkmalen des Anspruchs 1. Einzelne Ausgestaltungen der Erfindung sowie ein die Erfindung nutzender Sensor sind in den Unteransprüchen bzw. in Anspruch 5 angegeben.

Bei diesem mikroelektromechanischen Halbleiterbauelement ist erfindungsgemäß vorgesehen,
- dass die Deck- oder Bodenwand innerhalb ihres von den Gräben umgebenen zentralen Bereichs eine Vielzahl von die Masse des zentralen Bereichs reduzierenden Vertiefungen und eine Vielzahl von die Vertiefungen trennenden Versteifungsstreben aufweist.

Mit der Erfindung wird also vorgeschlagen, den zentralen Bereich der flexiblen Deck- oder Bodenwand der Kavität durch eine Strukturierung so zu verändern, dass die Masse der Deck- bzw. Bodenwand vermindert ist, ohne deren mechanische Stabilität zu ändern; diese bleibt vielmehr im Wesentlichen unverändert. Damit reduziert sich die seismische Sensitivität des mikroelektromechanischen Halbleiterbauelements.

Die Anordnung und Anzahl sowie Ausformung der Vertiefungen sowie der Versteifungsstreben wird von dem Erfordernis der unveränderten mechanischen Stabilität der flexiblen Deck- bzw. Bodenwand bestimmt. So können die Vertiefungen quadratisch bzw. quadratisch flächenzentriert angeordnet sein. Mit anderen Worten kann vorgesehen sein, dass die Vertiefungen und die Versteifungsstreben jeweils längs sich insbesondere orthogonal zueinander erstreckender Linien angeordnet sind bzw. verlaufen. Die Versteifungsstreben sind insbesondere in Form eines Gitters angeordnet, wobei die Felder, die von den Gitterstreben begrenzt sind, grundsätzlich jede beliebige Form aufweisen können. Als zweckmäßig hat sich beispielsweise eine Anordnung von Vertiefungen und Versteifungsstreben herausgestellt, die sich aus beispielsweise einer zweidimensional dichtesten (Kugel-)Packung ergibt. Die Erfindung ist jedoch auf diese Struktur nicht beschränkt. Jede Struktur, die bei geringem Gewicht eine hohe Steifigkeit der Deck- bzw. Bodenwand in deren Ebene hervorruft, ist für die Erfindung geeignet.

In vorteilhafter Weiterbildung der Erfindung ist ferner vorgesehen, dass das mindestens eine gegenüber mechanischen Spannungen empfindliche Mess- element ein Widerstand, ein Transistor, insbesondere ein piezoresistives Bauelement, ist.

Erfindungsgemäß ist vorgesehen, dass mehrere gegenüber mechanischen Spannungen empfindliche Messelemente zu einer Messbrücke verschaltet sind.

Mit Hilfe des erfindungsgemäßen mikroelektromechanischen Halbleiterbauelements lassen sich beispielsweise Druck- oder Beschleunigungssensoren konstruieren. Dabei kann der Drucksensor als Absolut- oder als DifferenzDrucksensor ausgebildet sein.

Die Erfindung wird nachfolgend anhand der Zeichnung näher erläutert. Im Einzelnen zeigen dabei:
- Fig. 1: Prozess zur Herstellung einer erfindungsgemäßen Struktur:
a) Roh-Wafer
b) Oxidation und Fensteröffnung
c) Ätzung der Kavität
d) Aufbonden des Top-Wafers (es folgt der CMOS Prozess, der nicht extra gezeigt wird)
e) Ätzen der Gräben (nach CMOS Prozess).
- Fig. 2: Dreidimensionaler vereinfachter Schnitt durch einen Drucksensor, der nach dem Prozess aus Fig. 1 hergestellt wurde.
- Fig. 3: Alternativer zweiter Prozess zur Herstellung einer erfindungsgemäßen Struktur:
a) Roh-Wafer
b) Oxidation und Fensteröffnung
c) Ätzung der Kavität
d) Aufbonden des Handle-Wafers (es folgt der CMOS Prozess auf dem Top-Wafer mit Kavität, der nicht extra gezeigt wird)
e) Ätzen der Gräben (nach CMOS Prozess).
- Fig. 4: Dreidimensionaler vereinfachter Schnitt durch einen Drucksensor, der nach dem Prozess aus Fig. 3 hergestellt wurde.
- Fign. 5 bis 10: Alternativer dritter Prozess zur Herstellung einer erfindungsgemäßen Struktur:
a) Roh-Wafer
b) Oxidation
c) Aufbringen einer Polysiliziumschicht und Anoxidation
d) 2. Roh-Wafer
e) Oxidation und Öffnung eines Fensters
f) Ätzung der Kavität
g) Aufbonden des Handle-Wafers
h) Anschleifen (es folgt der CMOS Prozess auf dem Top-Wafer mit Kavität, der nicht extra gezeigt wird)
i) Ätzen der Gräben (nach CMOS Prozess)
j) Dreidimensionaler vereinfachter Schnitt durch einen Drucksensor, der nach dem Prozess aus Fign. 5 bis 9 hergestellt wurde.

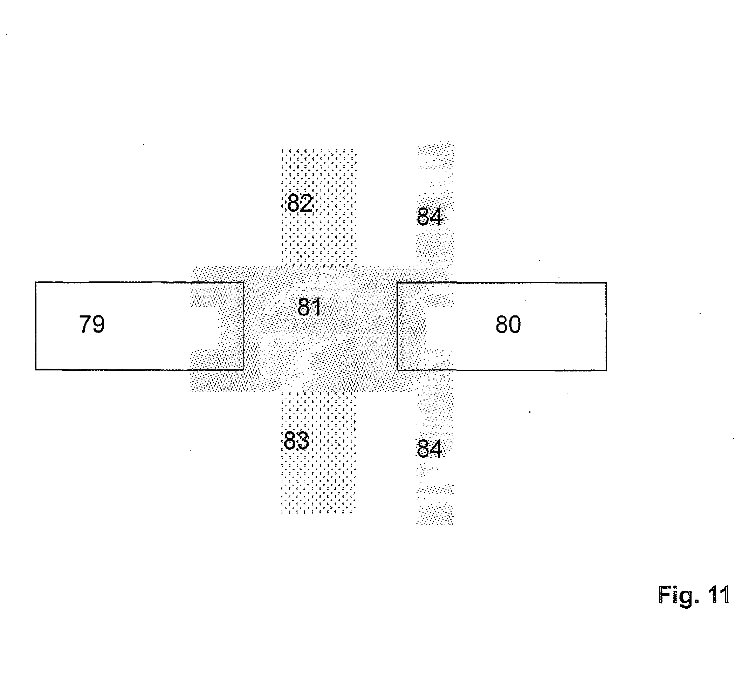

- Fig. 11: Beispiel für das Layout eines Transistors.

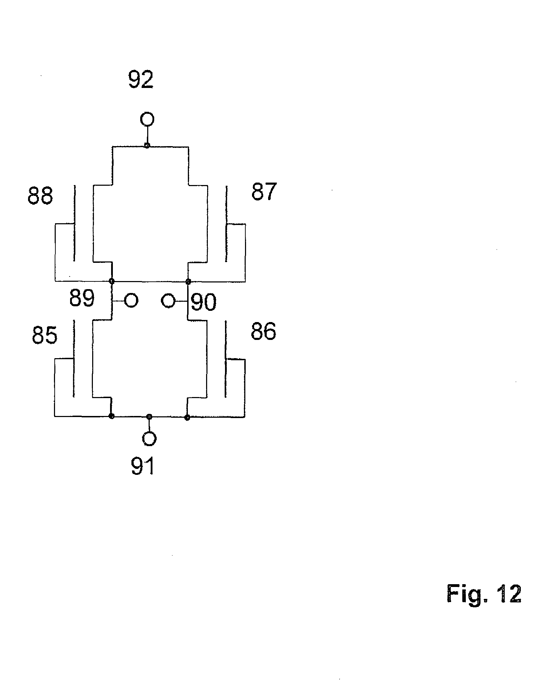

- Fig. 12: Verschaltung von vier Transistoren zu einer Wheatstone-Brücke (Betrieb der Transistoren als Widerstände).

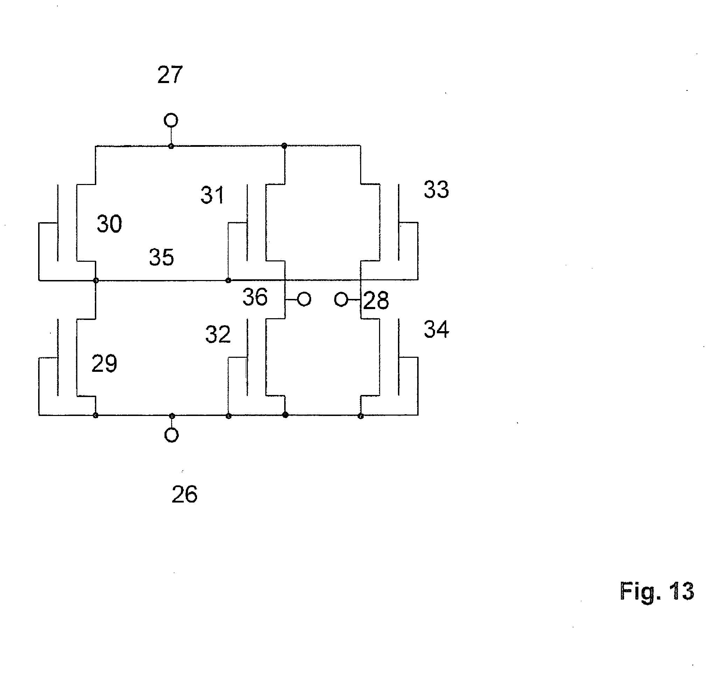

- Fig. 13: Beispielhafte Verschaltung von vier Transistoren und zwei weiteren zu einer Wheatstone-Brücke mit Referenzspannungsquelle.

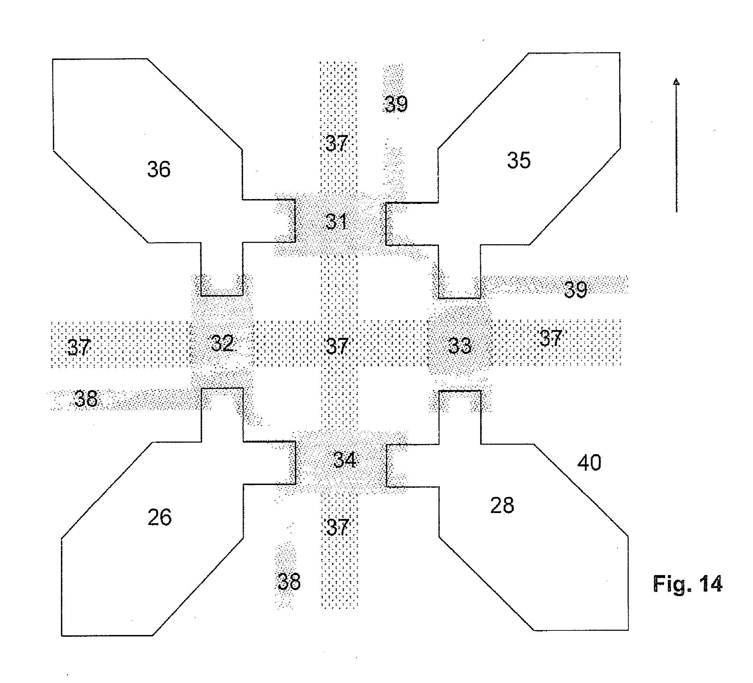

- Fig. 14: Layoutbeispiel für eine Wheatstone-Brücke.

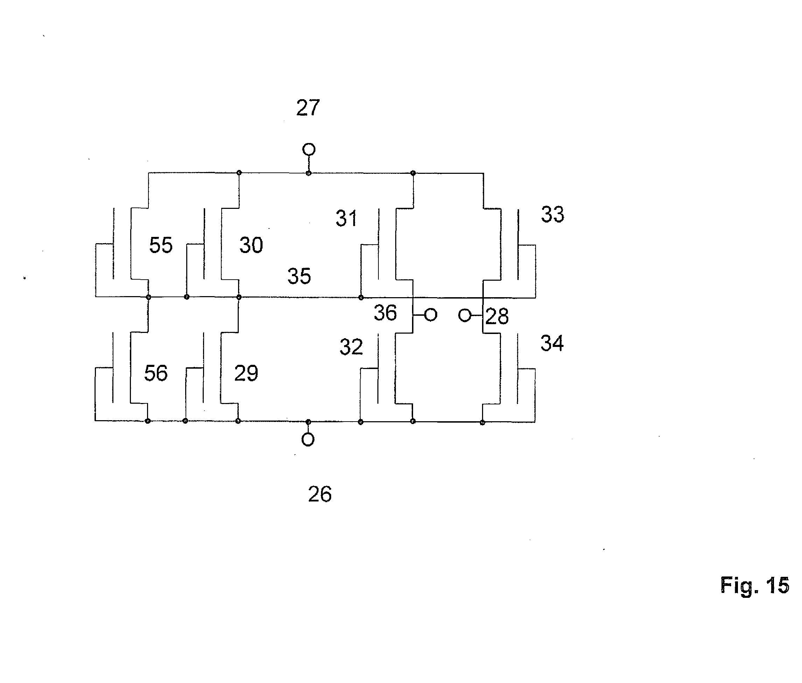

- Fig. 15: Verschaltung von acht Transistoren zu einer Wheatstone-Brücke mit einer zweiten kurzgeschlossenen Wheatstone-Brücke als Referenzspannungsquelle.

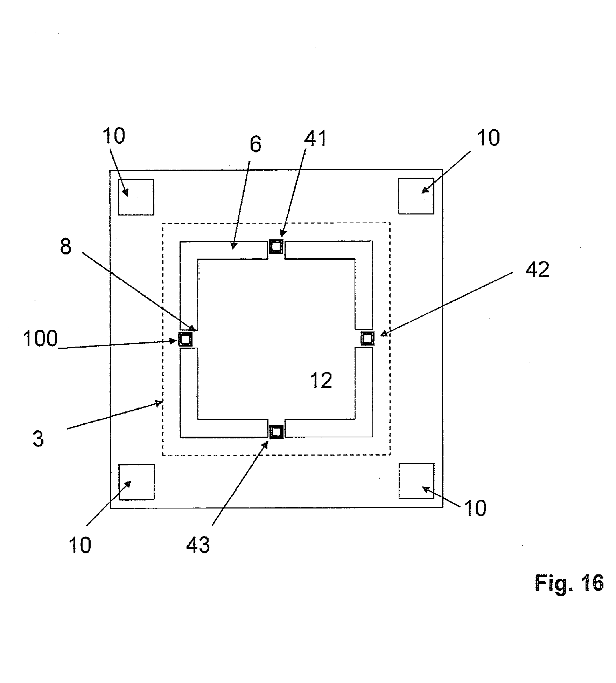

- Fig. 16: Platzierungsbeispiel von vier Wheatstone-Brücken nach Fig. 12 auf einem Sensor-Die mit Grabenstruktur.

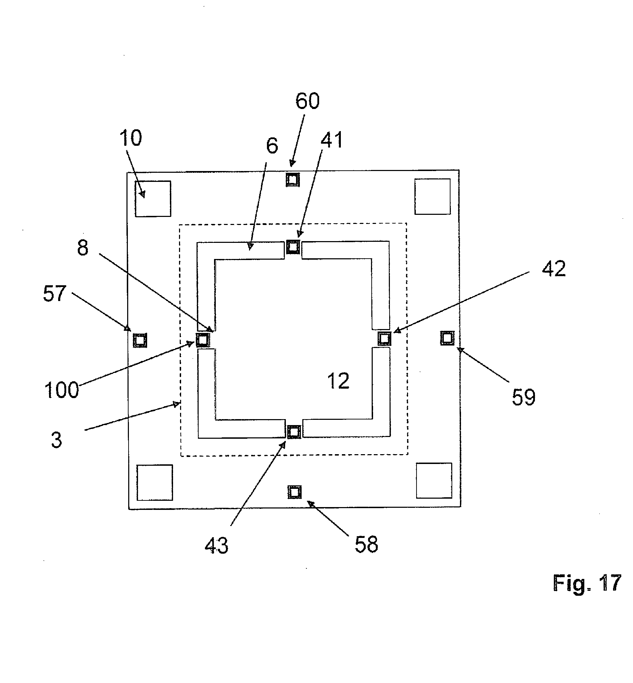

- Fig. 17: Platzierungsbeispiel von vier Wheatstone-Brücken mit vier Wheatstone-Brücken als stressfreie Referenzen nach Fig. 15 auf einem Sensor-Die mit Grabenstruktur (Die Spannungsreferenzen sind zur Übersichtlichkeit nicht eingezeichnet. Es reicht hier bei jedem Wheatstone-Brücken-Paar im Prinzip eine dritte, kurzgeschlossene Wheatstone-Brücke neben der stressfreien Referenzbrücke. Somit wären 12 Wheatstone-Brücken auf dem Die zu finden).

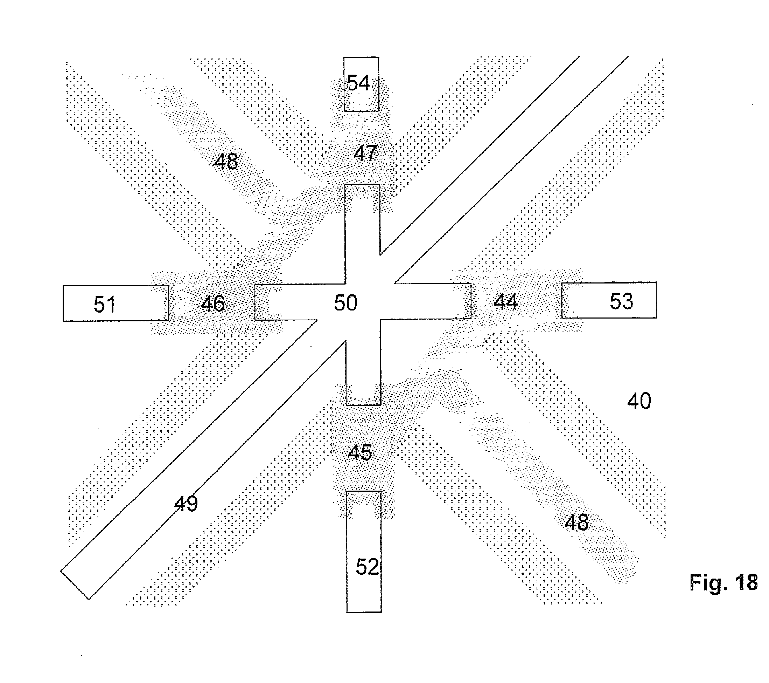

- Fig. 18: Layoutbeispiel für eine Differenzstufe.

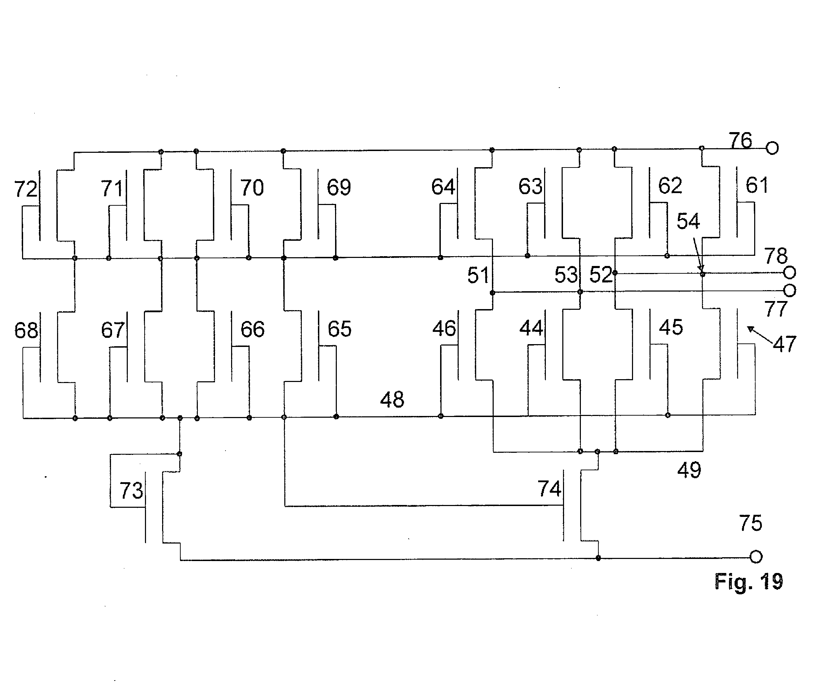

- Fig. 19: Schaltungsbeispiel für eine Schaltung mit einem Differenzverstärker und einem Referenzdifferenzverstärker als Referenzspannungsquelle.

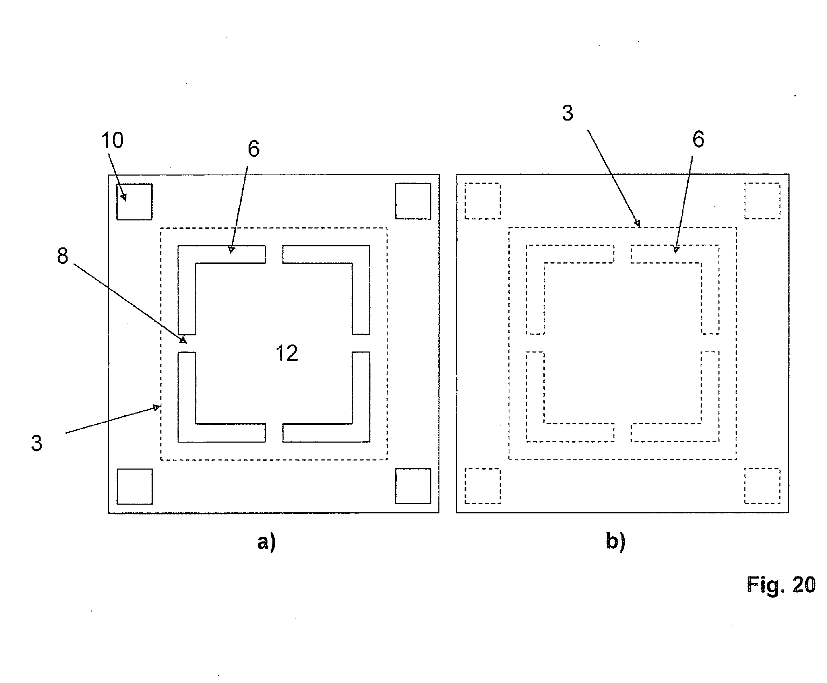

- Fig. 20: Sicht auf eine beispielhafte Membran-Geometrie mit quadratischem Grabensystem
a) Aufsicht
b) Ansicht von unten.

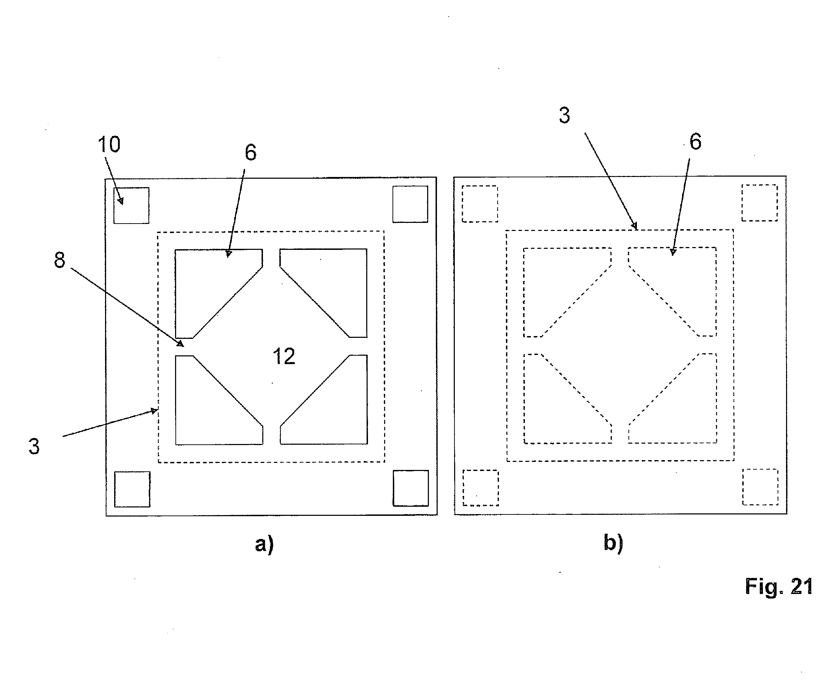

- Fig. 21: Sicht auf eine beispielhafte Membran-Geometrie mit quadratischem Grabensystem und rautenförmigem Zentralteil
a) Aufsicht
b) Ansicht von unten.

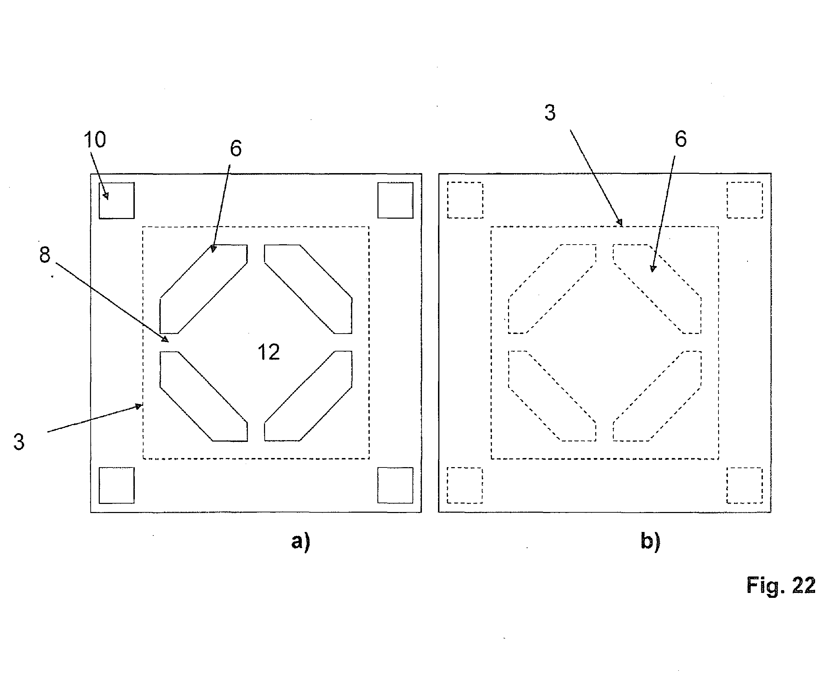

- Fig. 22: Sicht auf eine beispielhafte Membran-Geometrie mit quadratischem Grabensystem, das in den Ecken angephast wurde, und rautenförmigem Zentralteil
a) Aufsicht
b) Ansicht von unten.

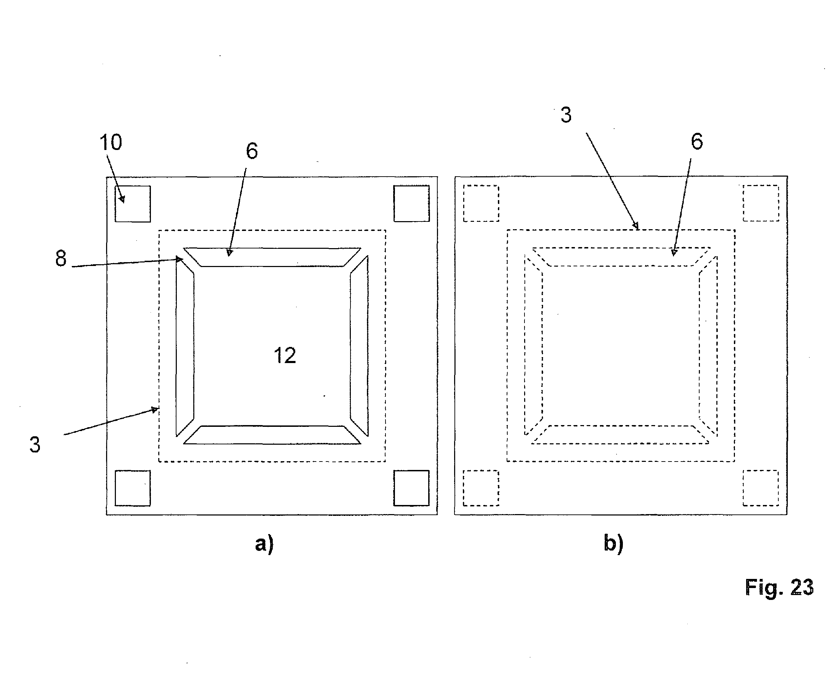

- Fig. 23: Sicht auf eine beispielhafte Membran-Geometrie mit quadratischem Grabensystem und Stegen in den Ecken
a) Aufsicht
b) Ansicht von unten.

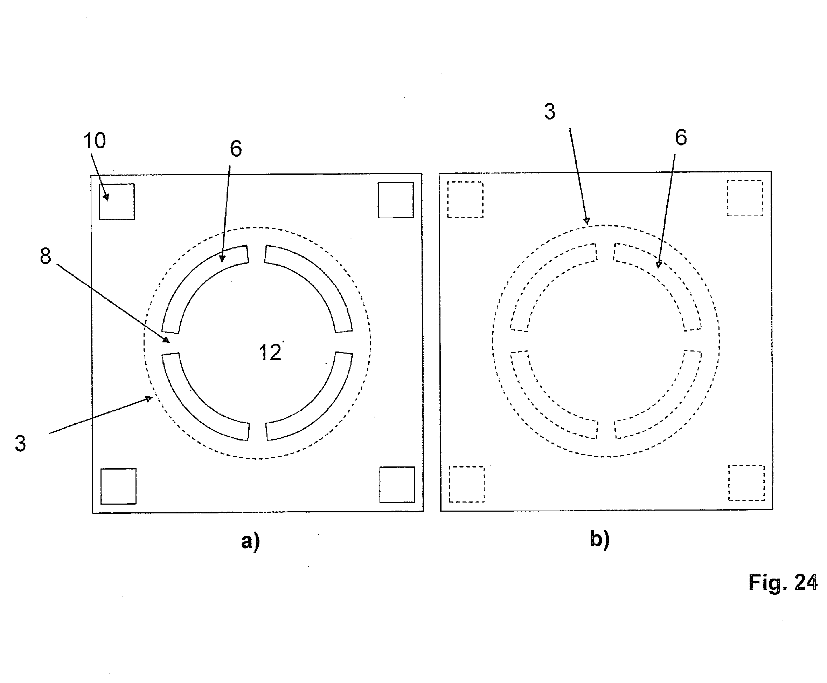

- Fig. 24: Sicht auf eine beispielhafte Membran-Geometrie mit rundem Grabensystem und runder Kavität
a) Aufsicht
b) Ansicht von unten.

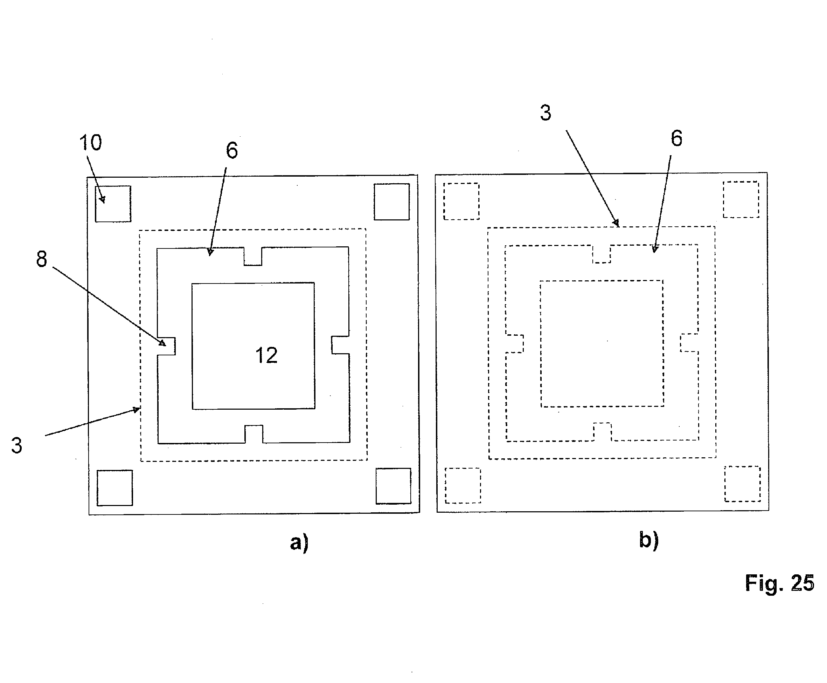

- Fig. 25: Sicht auf eine beispielhafte Membran-Geometrie mit quadratischem Grabensystem und nicht durchgezogenen Stegen
a) Aufsicht
b) Ansicht von unten.

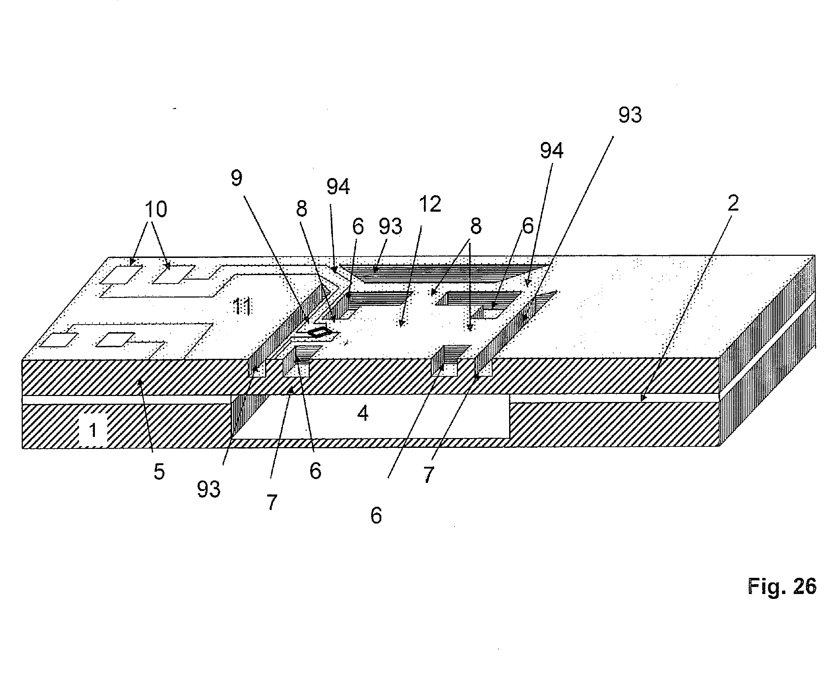

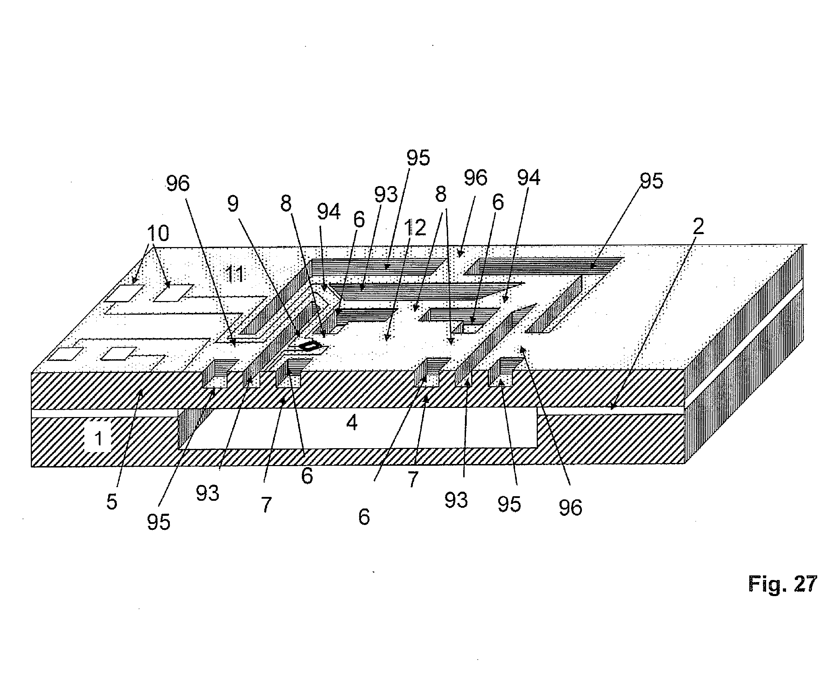

- Fign. 26 und 27: Sensoren mit zusätzlichen Gräben.

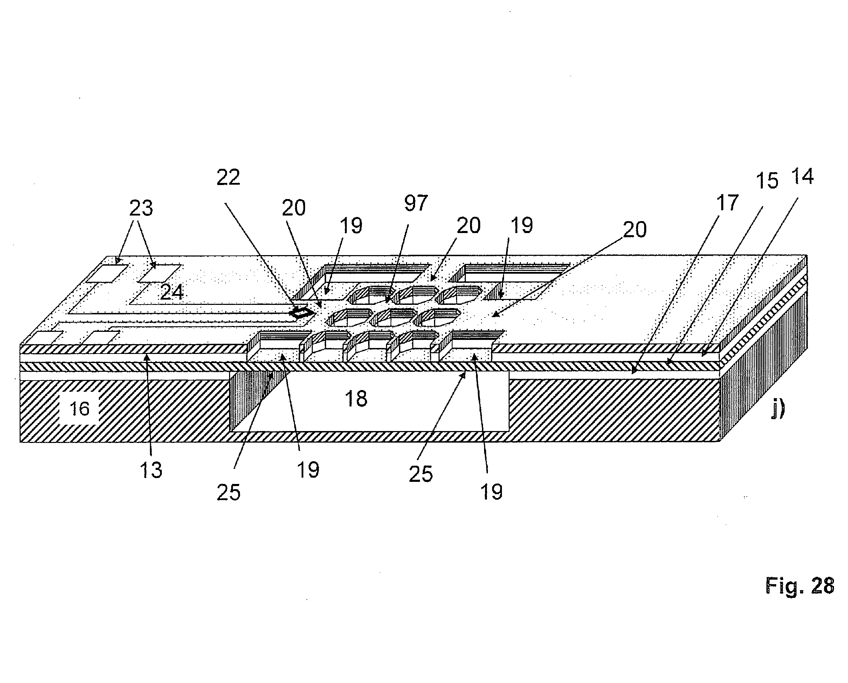

- Fig. 28: Boss (zentrale Membranversteifung) mit Masseverminderung durch geätztes Tragwerk 97.

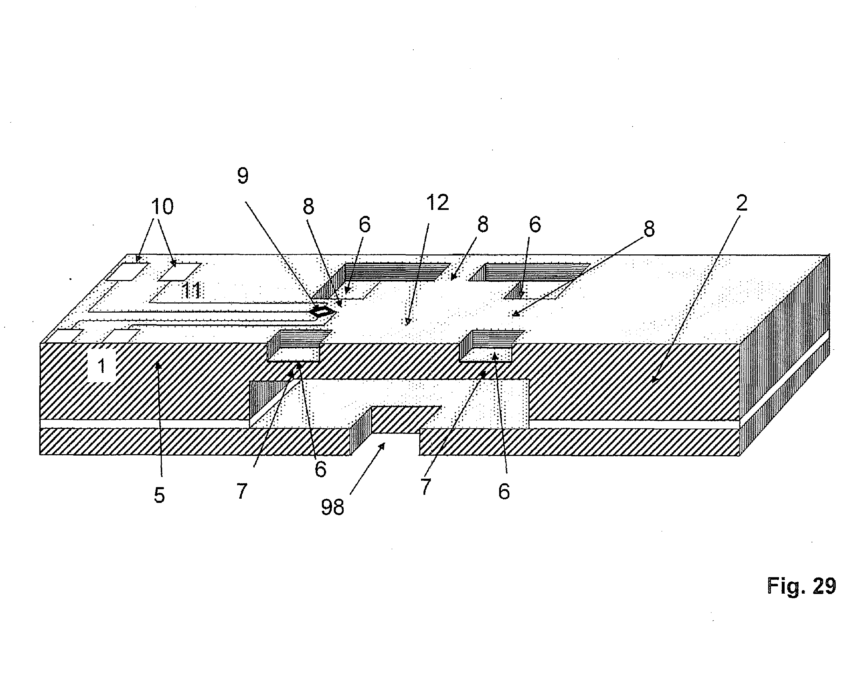

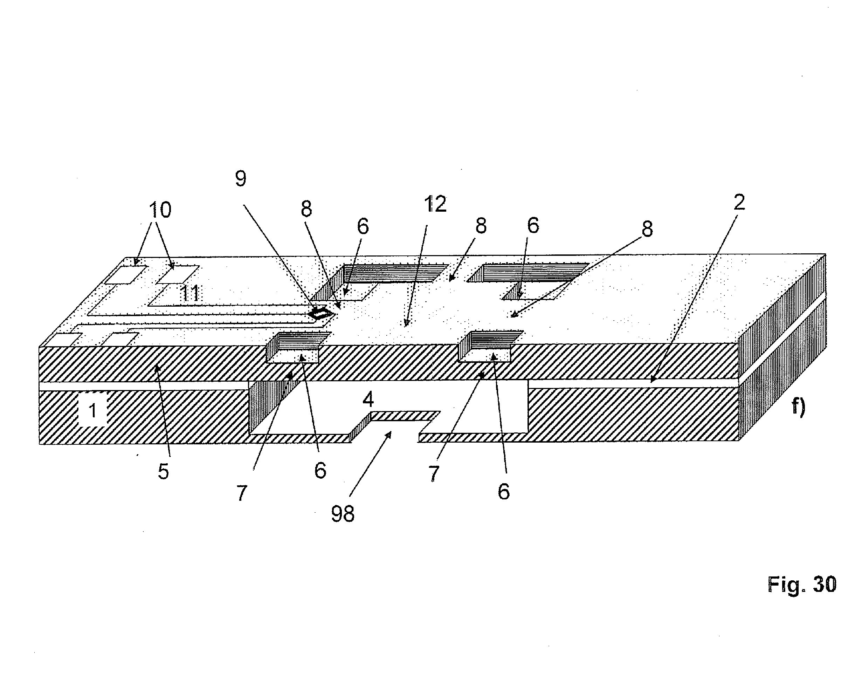

- Fign. 29 und 30: Beispielhafte Differenzdrucksensoren, die aus den obigen Sensoren durch Ätzung einer Öffnung 119 entstehen.

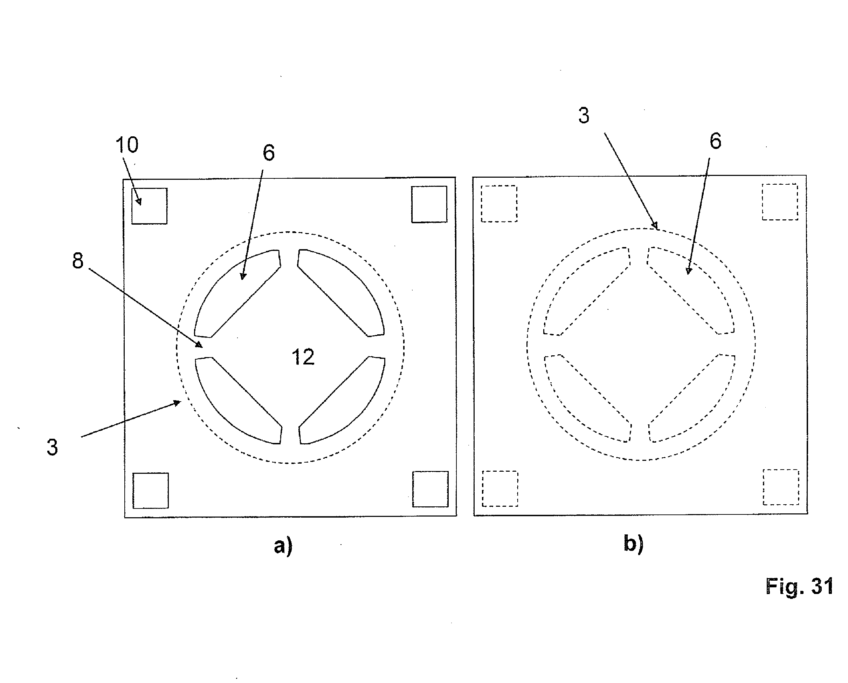

- Fig. 31: Sicht auf eine beispielhafte Membran-Geometrie mit runder Kavität, runder Außenkante des Grabensystems und rautenförmigem Zentralteil
a) Aufsicht
b) Ansicht von unten.

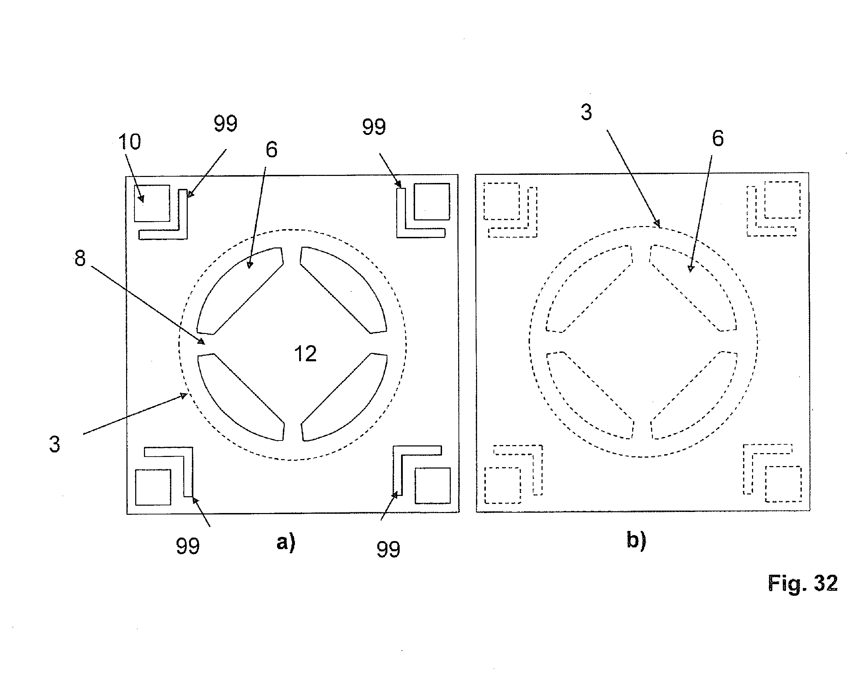

- Fig. 32: Sicht auf eine beispielhafte Membran-Geometrie mit runder Kavität, runder Außenkante des Grabensystems und rautenförmigem Zentralteil und zusätzlichen Gräben zum Schutz des Systems gegen Ausbreitung von extern eingetragenem Stress
a) Aufsicht
b) Ansicht von unten.

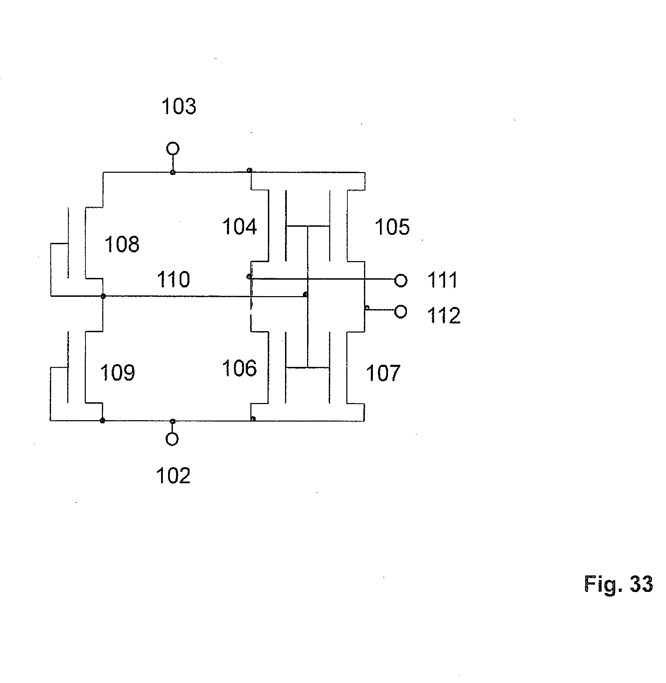

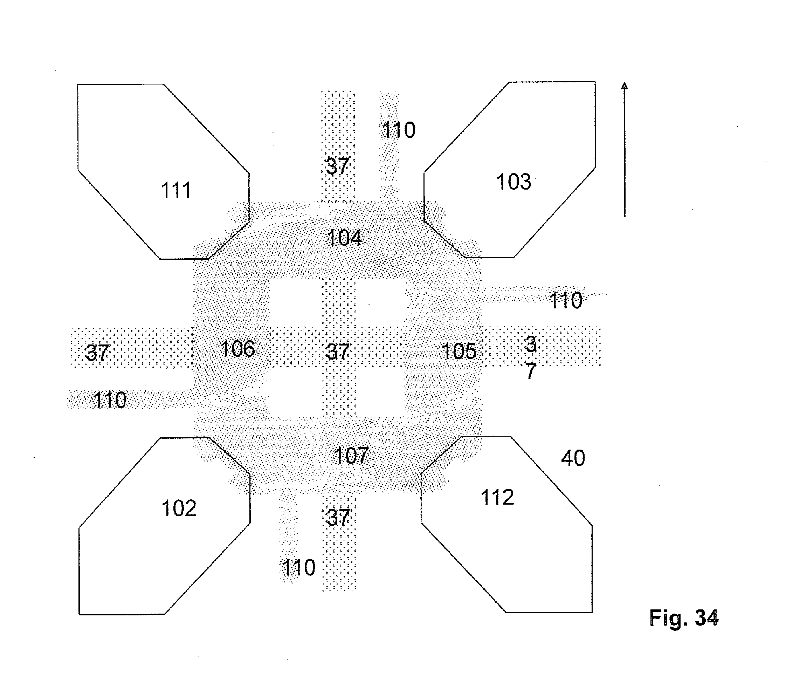

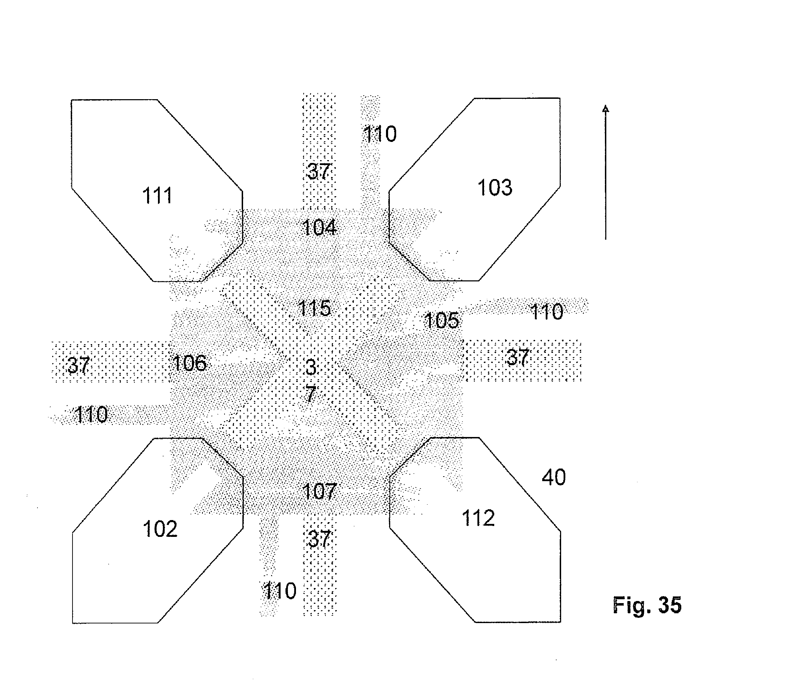

- Fig. 33: Schaltbild einer Brücke nach Fig. 34 und Fig. 35 als Messbrücke mit Referenzspannungsquelle.
- Fig. 34: Layoutbeispiel einer Messbrücke mit gemeinsamem Gate.
- Fig. 35: Weiteres Layoutbeispiel einer Messbrücke mit gemeinsamem Gate.

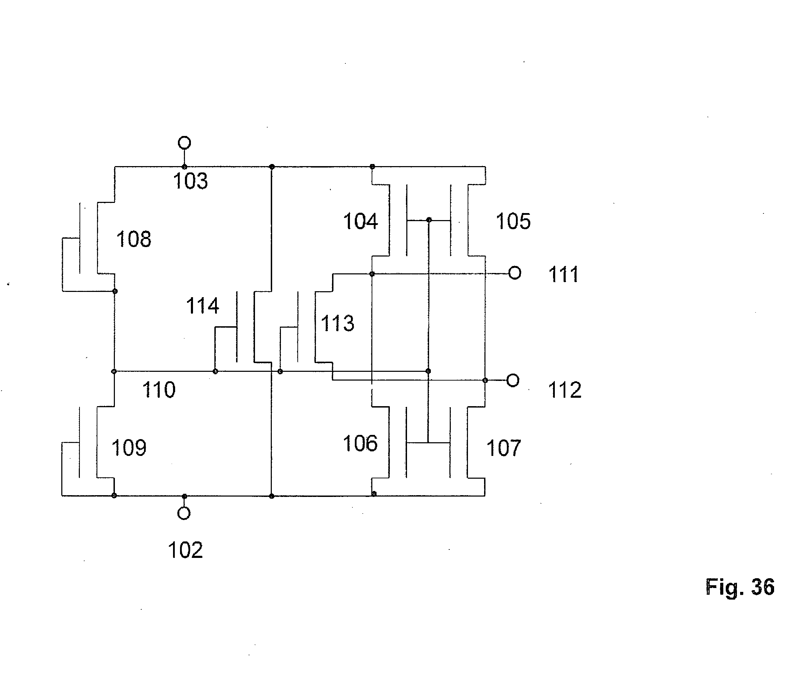

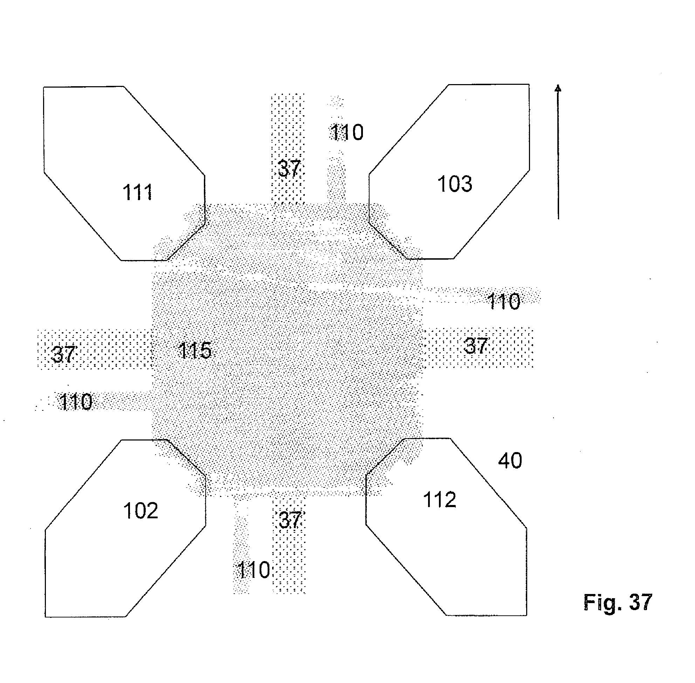

- Fig. 36: Ersatzschaltbild eines Transistors nach Fig. 37 als Messbrücke mit Referenzspannungsquelle.
- Fig. 37: Layoutbeispiel eines besonders kleinen Messbrückentransistors mit vier Anschlüssen.

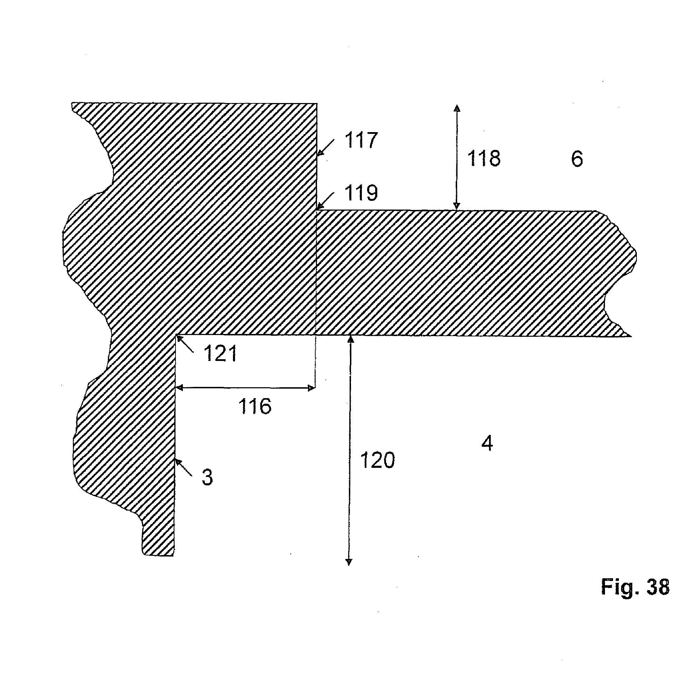

- Fig. 38: Eine Detaildarstellung.

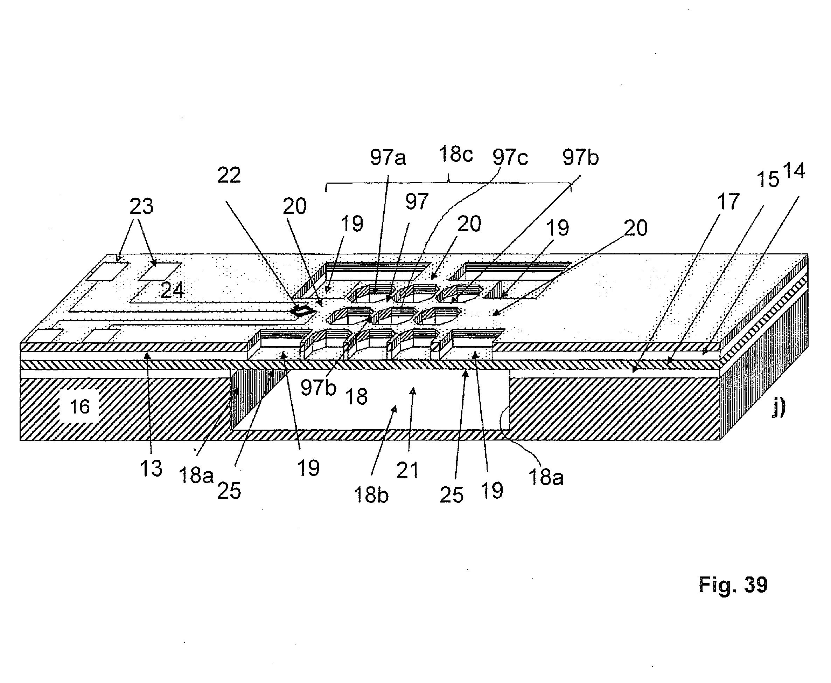

- Fig. 39: eine nochmalige Darstellung eines erfindungsgemäßen mikroelektromechanischen Halbleiterbauteils mit massereduziertem Boss.

Die Erfindung wird am Beispiel eines Drucksensors für die Detektion niedriger Drücke dargestellt. Ein erster wesentlicher Punkt für die Erfindung ist die Anfertigung der Drucksensor-Kavität 4 vor der Prozessierung der CMOS Schritte. Hierdurch können beliebige Standard-CMOS-Prozesse auf der Oberfläche durchgeführt werden. Dies ermöglicht es als zweiten wesentlichen Schritt CMOS Transistoren auf einer Membrane so zu platzieren, dass sie in einem Bereich optimalen mechanischen Stresses bei Auslenkung der Membrane liegen. Dieser Punkt kann durch analytische Überlegungen und/oder Finite-Elemente-Simulationen bestimmt werden.

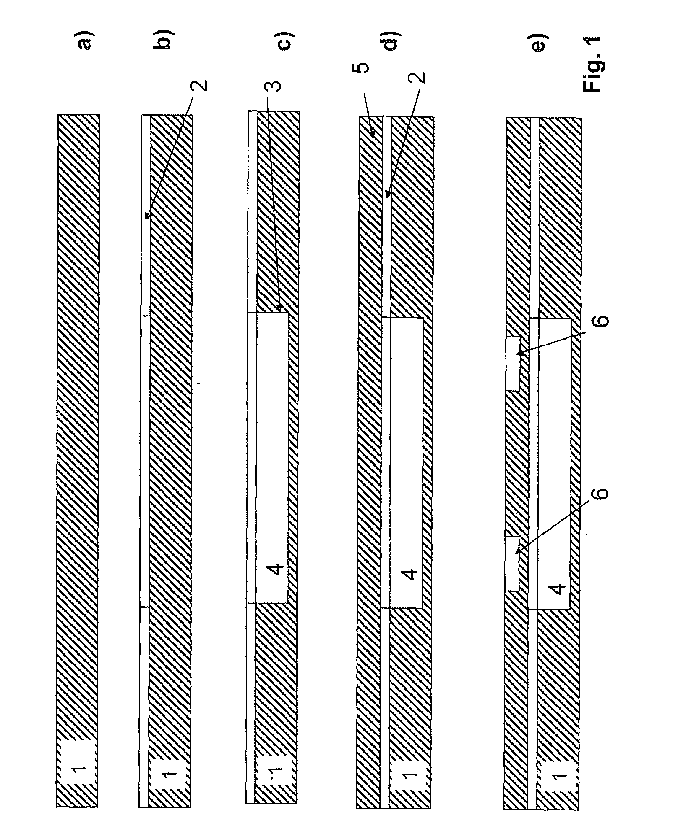

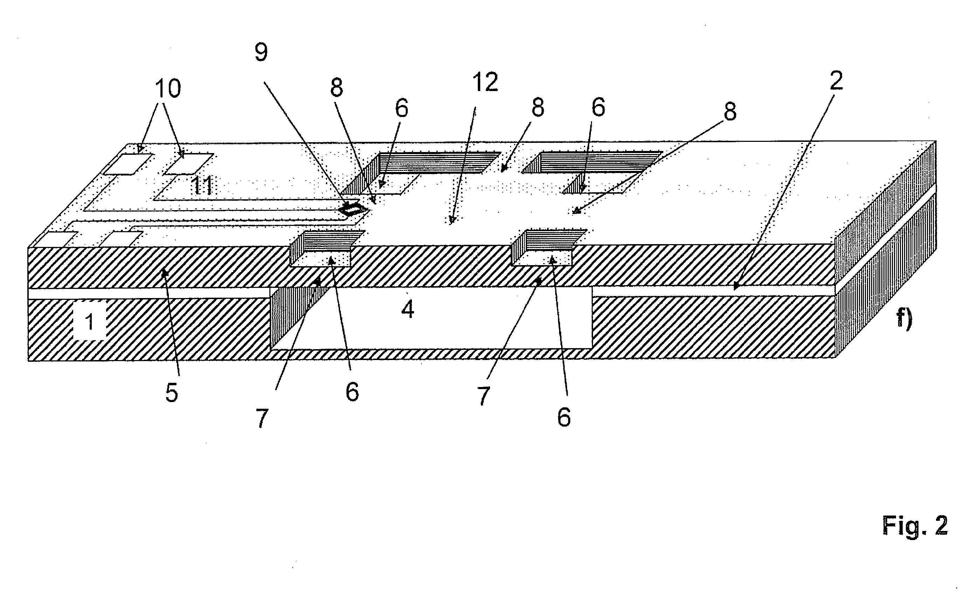

Ein erster beispielhafter Prozess ist in wesentlichen Schritten in den Fign. 1 und 2 dargestellt. Abwandlungen dieses ersten Prozesses werden im weiteren Verlauf beschrieben.

Der grundlegende Herstellungsprozess beginnt mit einem ersten Wafer 1, der vorzugsweise aus dem gleichen Material wie ein später verwendeter zweiter Wafer 5 ist. Auf diesem Wafer wird eine Schicht 2 abgeschieden, die der späteren Verbindung dient. Bei Silizium-Wafern bildet man diese als eine SiO₂-Schicht 2 durch Oxidation aus. In dieser Schicht wird ein Fenster geöffnet und die spätere Drucksensor-Kavität 4 geätzt. (Fig. 1c) Diese Ätzung erfolgt vorzugsweise durch einen DRIE- oder Plasma Ätzschritt, da insbesondere der erstere zu geraden Wänden 3 führt.

Der obere Wafer 5 wird ebenfalls mit einer Oxidschicht versehen und auf den ersten Wafer 1 gebondet und geschliffen. (Fig. 1d) Der Bondprozess wird hierbei vorzugsweise in einem Vakuum ausgeführt. Dies führt zu einer Kavität die nicht mit Gas gefüllt ist und schließt eine spätere Temperaturabhängigkeit des Binnendruckes in der Kavität aus. Durch diesen Prozess entsteht im Bereich der Kavität 4 eine Membrane deren Dicke durch den Schleifprozess bestimmt wird.

Als Ergebnis erhält man ein Wafer-Paket, das in einem Standard-CMOS-Prozess oder Standard-Bipolar-Prozess wie normales SOI-Material verwendet werden kann.

Nach der CMOS Prozessierung, die hier nicht näher beschrieben zu werden braucht, da die Prozessierung der Standard Literatur entnommen werden kann, können dann weitere mikromechanische Strukturen 6 in die Oberfläche 11 geätzt werden. (Fig. 1e).

Im Falle des beispielhaften Drucksensors sind diese mikromechanischen Strukturen 6 beispielsweise Grabenstrukturen, die näherungsweise geschlossene Ringe oder Vierecke bilden, die nur durch wenige Stege 8 unterbrochen (Fig. 2). Hierbei entsteht in der Mitte eine Zentralplatte 12 - Boss genannt -, die infolge der größeren Dicke eine Versteifung darstellt. Der Boden der Gräben 6 stellt eine Membrane geringerer Dicke dar 7. Diese nimmt typischerweise wesentlich weniger Kräfte auf. Wichtig ist hierbei, dass die äußere Kante des Grabens 6 ausreichend weit von der Wand der Kavität 3 entfernt ist, da ansonsten kleine Justierfehler in der Fertigung eine große Auswirkung auf den mechanischen Stress und damit auf das Messresultat hätten. Dies ist eine wesentliche Neuerung. Die fertigungstechnische Reproduzierbarkeit der Sensoreigenschaften würde somit leiden, was einen erhöhten Kalibrationsaufwand und damit entsprechende Kosten zur Folge hätte.

Somit wird der Druck auf die Zentralplatte 12 praktisch ausschließlich über mechanische Zugspannung über die Stege 8 abgeleitet. Daher ist es sinnvoll auf diese Stege die Bauteile 9 zu platzieren, die gegen mechanischen Stress empfindlich sind und diesen Stress detektieren sollen. Diese sind dann über Leitungen mit den Anschlüssen 10 verbunden. Durch die Gräben wird also das mechanische Stressfeld gegenüber den stresssensitiven elektronischen Bauteilen justiert.

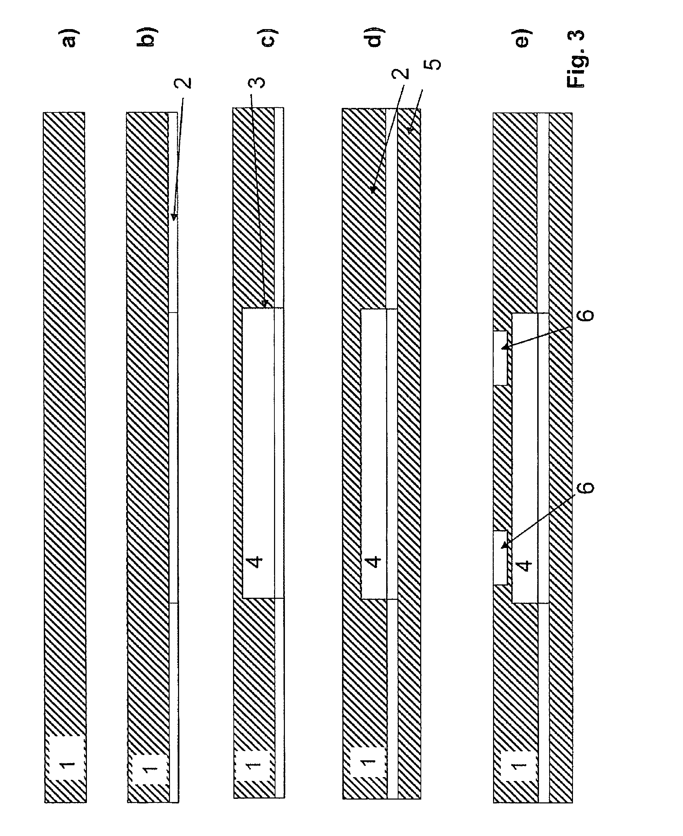

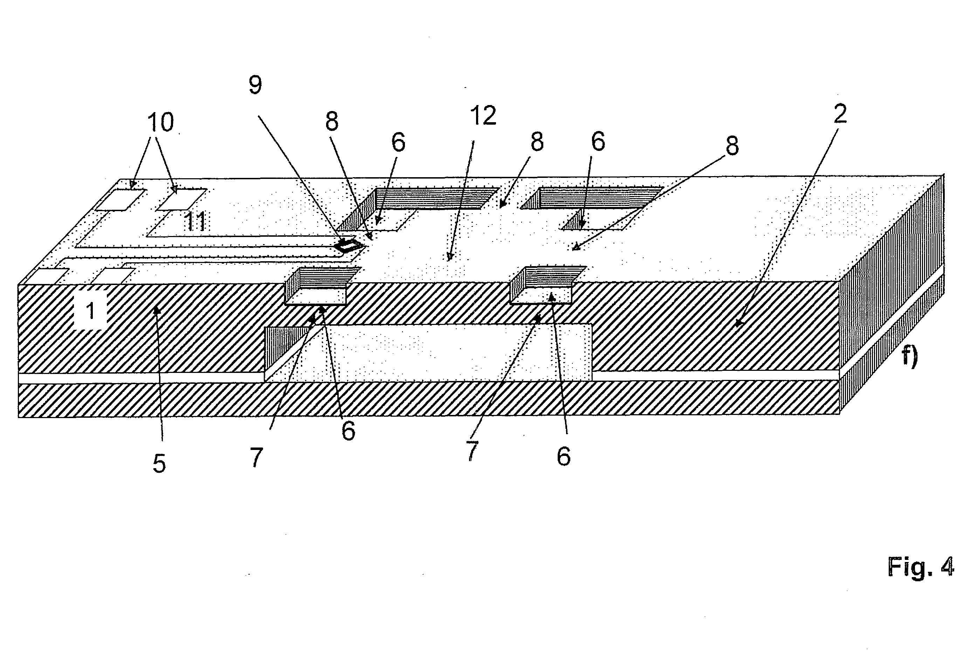

Alternativ kann die Kavität auch in den oberen Wafer geätzt werden. Dies ist in den Fign. 3 und 4 entsprechend in den Schritten a bis f dargestellt.

Ein wesentlicher Nachteil der beiden vorangehenden Prozesse ist das Fehlen eines natürlichen Ätzstops für die Ätzung der Gräben 6. Daher ist die Dicke der Membrane am Grunde der Gräben 7 nur schwer zu kontrollieren. Der relative Fehler ist daher verhältnismäßig hoch, was zu einer Streuung der Sensorparameter führt.

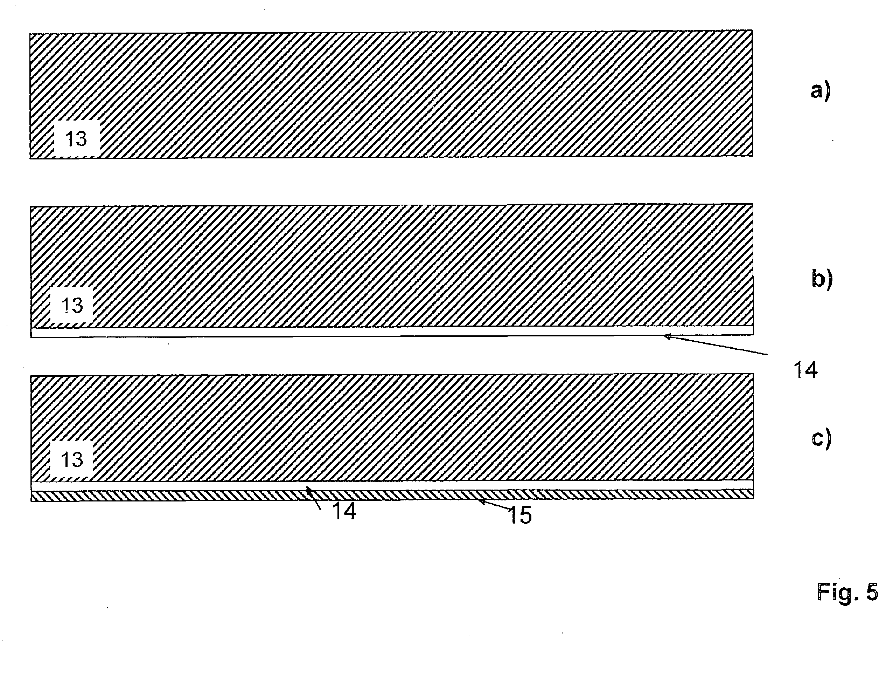

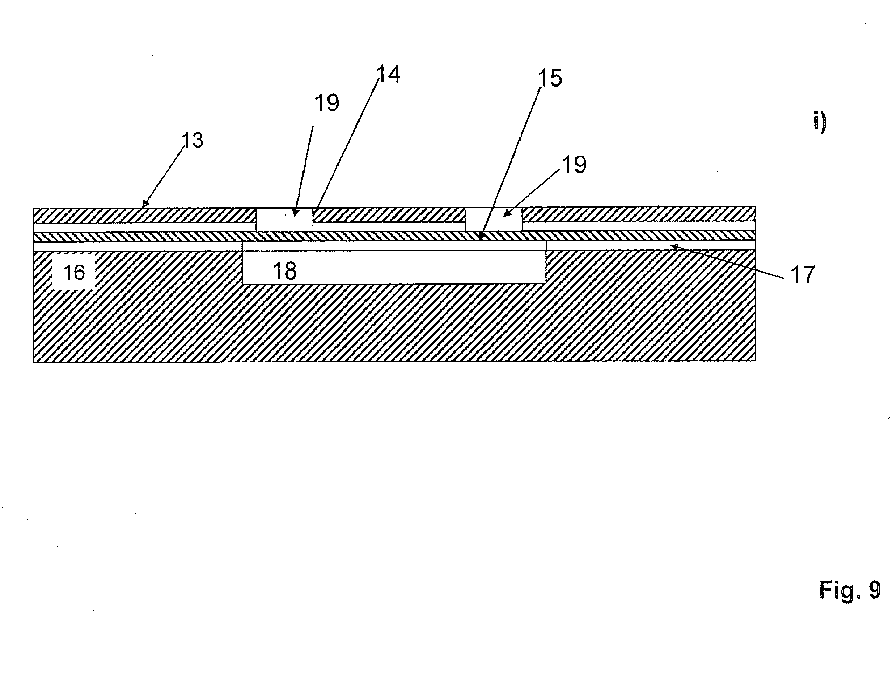

Ein dritter beispielhafter Prozess, der diesen Nachteil nicht aufweist, ist in wesentlichen Schritten in den Fign. 5 bis 10 und Schritten a bis j dargestellt.

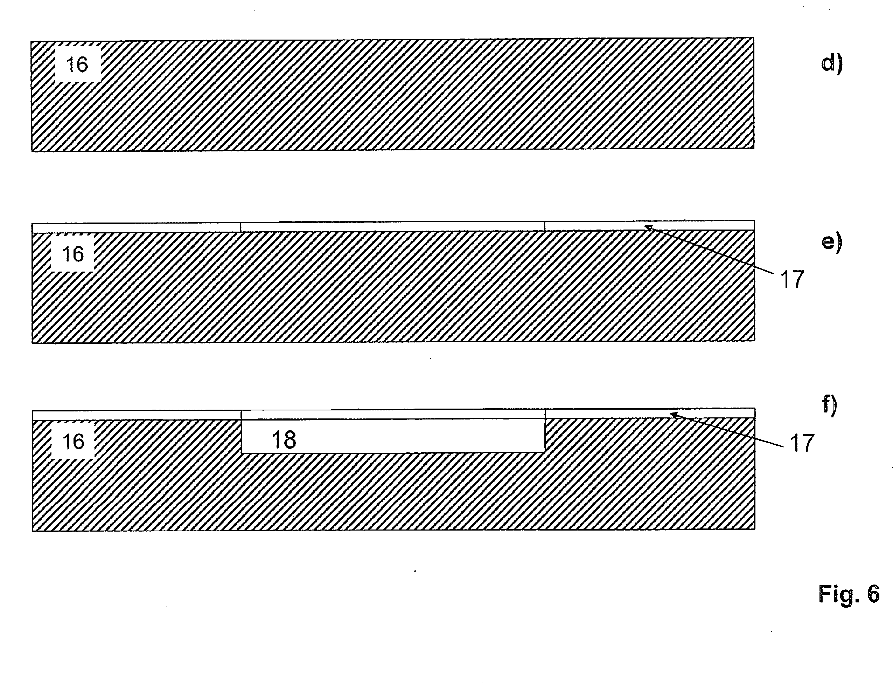

Der Herstellungsprozess beginnt mit einem ersten Wafer 13, der vorzugsweise aus dem gleichen Material wie der später verwendete zweite Wafer 16 ist. Auf diesem Wafer wird eine Verbindungsschicht, im Falle von Silizium-Wafern eine SiO₂-Schicht 14 Auf dieser SiO₂ Schicht wird eine weitere Schicht, beispielsweise eine Poly-Silizium-Schicht oder amorphe Siliziumschicht 15 abgeschieden und oberflächlich oxidiert (Fig. 5c). Die Abscheidung dieser Schicht kann typischerweise sehr gut kontrolliert werden und ist in ihrem Ergebnis daher wesentlich präziser als die Ätzung der Gräben in den ersten beiden beschriebenen Prozessen. Der zweite Wafer 16 wird ebenfalls oxidiert, sodass sich ebenfalls eine Oxidschicht 17 bildet. In diese wird mindestens ein Fenster geöffnet und die spätere Kavität 18 geätzt. Diese Ätzung erfolgt vorzugsweise durch einen DRIE Ätzschritt, da dieser zu geraden Wänden führt (Fig. 6f). Die Ätzung der Kavität 18 in den oberen Wafer 13 wird im Folgenden nicht weiter beschrieben, ist aber selbstverständlich ebenso möglich.

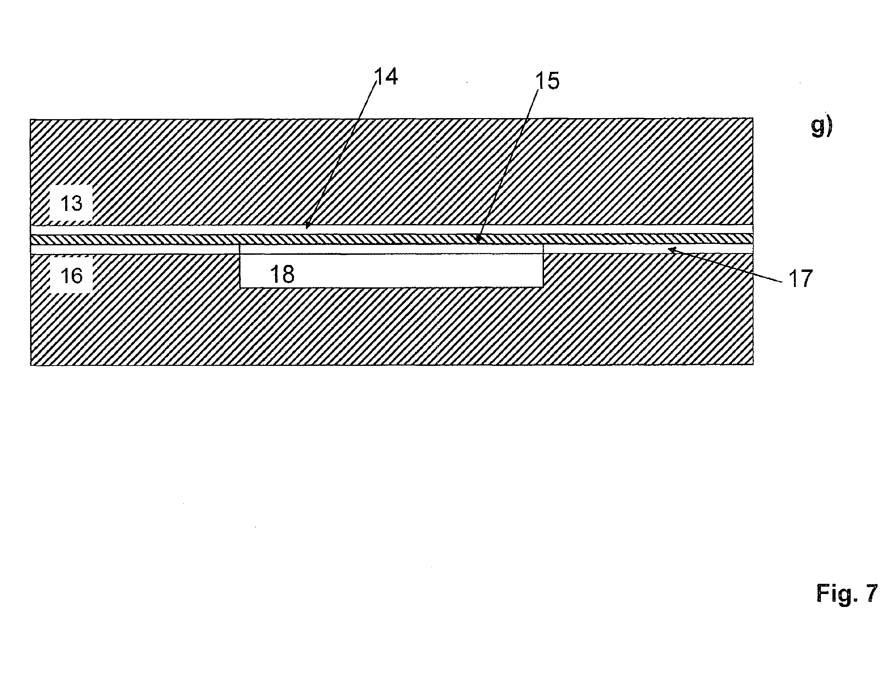

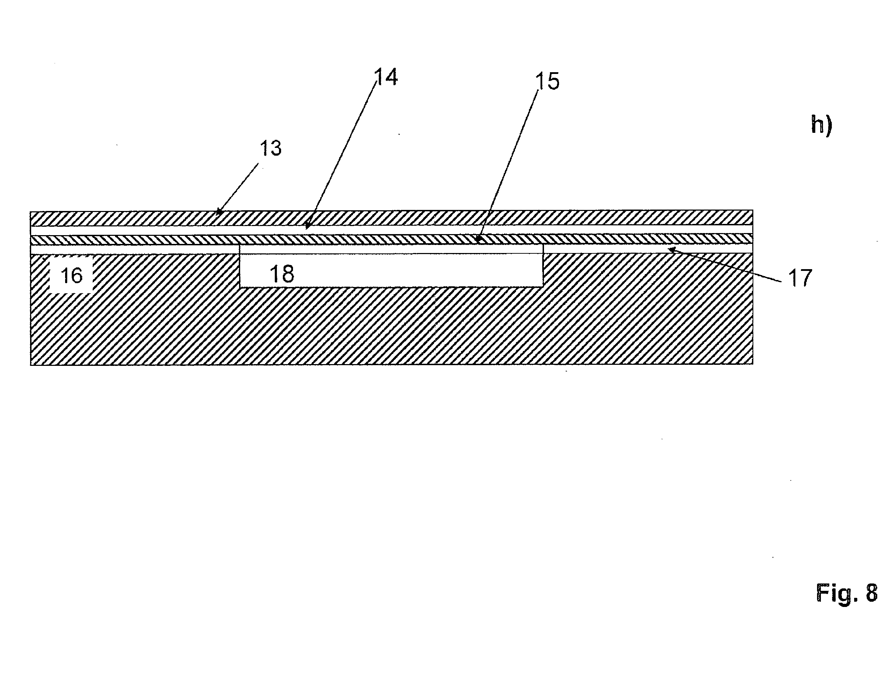

Der obere erste Wafer 13 wird auf den zweiten Wafer 16 gebondet (Fig. 7) und anschließend geschliffen (Fig. 8). Der Bondprozess wird hierbei vorzugsweise wieder in einem Vakuum ausgeführt, um eine spätere Temperaturabhängigkeit des Binnendruckes in der Kavität 18 auszuschließen. Hierdurch entsteht im Bereich der Kavität eine Membrane deren Dicke durch den Schleifprozess bestimmt wird.

Als Ergebnis erhält man wieder ein Wafer-Paket, das prinzipiell wie ein Standard-Wafer in einem Standard-CMOS-Prozess oder Standard-Bipolar-Prozess verwendet werden kann.

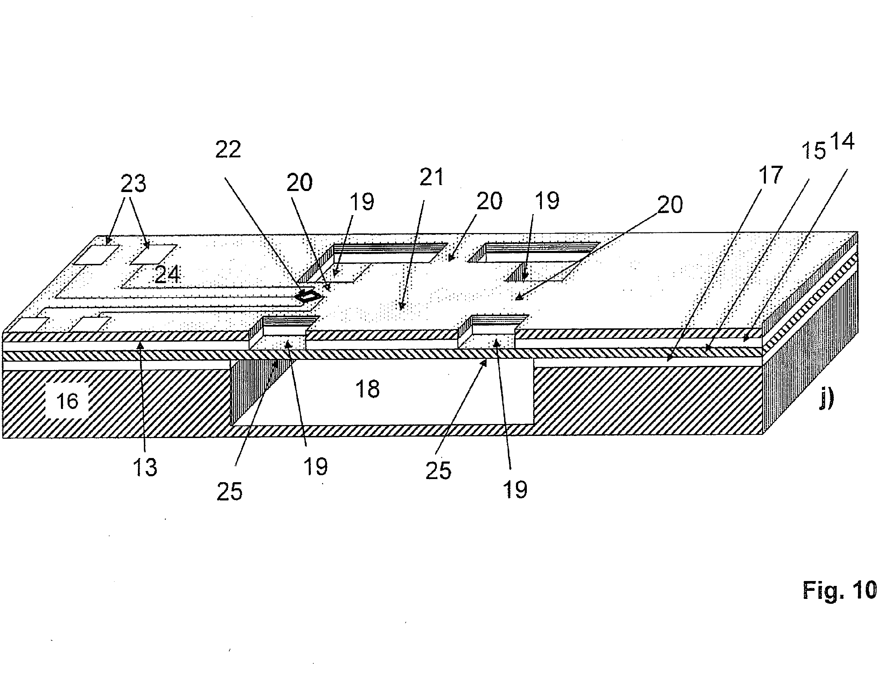

Nach der CMOS- oder Bipolar-Prozessierung können dann wie in den voraus beschriebenen Prozessen weitere mikromechanische Strukturen z.B. Gräben 19 in die Oberfläche 24 geätzt werden (Fig. 10).

Im Falle eines Drucksensors sind diese mikromechanischen Strukturen 19 wieder beispielsweise Grabenstrukturen, die näherungsweise geschlossene Ringe oder Vierecke bilden, die nur durch wenige Stege 20 unterbrochen sind. Hierbei entsteht wieder in der Mitte eine Zentralplatte 21, die infolge der größeren Dicke eine Versteifung darstellt. Der Boden der Gräben 19 stellt eine Membrane geringerer Dicke dar 25. Diese nimmt wieder praktisch keine Kräfte auf. Im Gegensatz zum ersten Verfahren kann durch die zusätzliche Schicht 15 und dies daraus folgende zusätzliche Oxid-Schicht 14 die Ätzung der Gräben 19 präziser als bei der ersten Methode gestoppt werden. Hierdurch können die elektromechanischen Eigenschaften präziser mit besserer Wiederholgenauigkeit gefertigt werden, was die Kalibrationskosten deutlich senkt.

Wie beim ersten Prozessergebnis wird der Druck (siehe Fig. 10) auf die Zentralplatte 21 praktisch ausschließlich über die Stege 20 abgeleitet. Daher ist es wiederum sinnvoll, auf diese Stege die elektronischen Bauteile 22 zu platzieren, die gegen mechanischen Stress empfindlich sind und diesen Stress detektieren sollen. Diese sind dann über Leitungen mit den Anschlüssen 23 verbunden.

Natürlich ist es auch denkbar, die zusätzliche Schicht 1.5 statt durch Abscheidung durch Aufbonden und Schleifen eines dritten Wafers herzustellen. Des Weiteren ist es denkbar, mehr als eine vergrabene isolierte Schicht der Art der zusätzlichen Schicht 15 in ein Wafer-Paket zu integrieren.

Mit einem solchermaßen hergestellten Wafer-Paket können wiederum stressempfindliche Sensoren auf der Membrane nach deren Herstellung vor Fertigung der Gräben (6 oder 19) gefertigt werden.

Hierzu werden in einem CMOS- oder Bipolar-Prozess stress empfindliche elektronische Bauelemente auf der jeweiligen Oberfläche 11,24 gefertigt und verschaltet. Für einen CMOS Prozess wird vorzugsweise ein p-dotiertes Substrat verwendet.

Beispielsweise können piezoresistive Widerstände auf den Stegen 20,8 platziert werden und als Wheatstone Brücke verschaltet werden. Diese haben jedoch den Nachteil, dass sie erst auf Betriebstemperatur gebracht werden müssen und relativ viel elektrische Energie bei einer Messung verbrauchen. Sie sind daher für energieautarke Systeme ungeeignet. Die Erfindung stellt sich wie oben bereits beschrieben daher auch die Aufgabe, dieses Problem auszuschließen.

Daher ist es sinnvoll, statt solcher einfacher elektronischer Bauelemente, aktiv verstärkende Elemente wie Bipolar-Transistoren und MOS-Transistoren zu verwenden. Diese können ebenfalls als Wheatstone Brücke verschaltet werden, benötigen aber keine Aufwärmzeit und verbrauchen weniger Energie. Eine beispielhafte Verschaltung zeigt Fig. 12.

Hierbei bilden vier p-Kanal-Transistoren 85,86,87,88 eine Wheatstone Brücke, die an den beiden Klemmen 89,90 abgegriffen werden kann. Hierbei werden die Transistoren 87 und 85 gleich orientiert konstruiert und das Transistorpaar 88,86 ebenfalls gleichorientiert, jedoch senkrecht zum Transistorpaar 87,85. Diese Schaltung ist jedoch sehr empfindlich gegenüber Fertigungsfehlern.

Um eine solche MOS-Transistorschaltung nun mit hinreichender Genauigkeit fertigen zu können, ist es notwendig, die Transistoren so zu gestalten, dass der elektrisch aktive Teil selbstjustierend ist. Fig. 11 zeigt das beispielhafte Layout eines solchen selbstjustierenden Transistors. Hierbei werden die p+ Kontaktimplantationen 80 und 79 durch das Poly-Gate 81 so abgeschattet, dass auch bei Versatz stets die gleiche Transistor-Kanallänge und Transistor-Weite verbleibt. Ebenso schattet das Poly-Gate 81 die n+ Channel-Stopp-Implantation ab. Das Gate wird über eine niederohmige Poly-Leitung angeschlossen.

Es ist somit sichergestellt, dass die Transistoren gleicher Entwurfsgeometrien eine sich gleichende Geometrie in ihrer physikalischen Realisierung haben. Diese wird wesentlich durch die Gestaltung der Poly-Silizium-Fläche bestimmt.

Um die Transistoren in den jeweils richtigen Arbeitspunkt zu bringen, ist es zweckmäßig, eine Referenzspannungsquelle mit auf den Drucksensor zu integrieren. In dem Beispiel (Fig. 13) besteht die beispielhafte Referenzspannungsquelle aus den Transistoren 30 und 29. Die Transistoren 31,32,33,34 bilden wieder eine Wheatstone-Brücke, die an den Klemmen 28,36 abgegriffen werden kann. Beide sind als MOS Dioden verschaltet indem das Gate mit Drain verbunden ist. Die Referenzspannung von Transistor 30 ist mit dem Gate von Transistor 31 und 33 verbunden. Die Referenzspannung von Transistor 29 ist mit dem Gate von Transistor 32 und 34 verbunden. Im Beispiel Fig. 13 liegt der Drain von Transistor 29 auf dem Potential der Klemme 26. Diese Klemme liegt bei p-Kanal-Transistoren typischerweise auf Masse. Daher sind die Drain-Kontakte der Transistoren 32 und 34 ebenfalls mit dieser Klemme verbunden. Die Transistoren werden vorzugsweise mit gleichen geometrischen Maßen ausgeführt. Das Layout-Beispiel einer lokalen Wheatstone-MOS-Brücke ist in Fig. 14 gegeben. Sind die Transistoren wie in Fig. 14 angeordnet, so sind die Transistoren 31 und 34 gleich orientiert. Die die Transistoren 23 und 33 sind ebenfalls zueinander gleichorientiert, jedoch senkrecht zu den Transistoren 31 und 34. Fig. 14 zeigt eine beispielhafte Anordnung.

Um die mechanischen Verspannungen auf der Membrane klein zu halten, ist diese nicht mit einem Feld-Oxid versehen sondern lediglich mit einem ganzflächigen äußerst dünnen Gate-Oxid von wenigen nm und einer geeigneten Passivierung. Sofern das Aufbringen eines Feldoxides unvermeidlich ist, ist eine hohe Symmetrie sinnvoll, um Parasitäre Effekte auf alle stressempfindlichen Bauteile gleich zu halten. Die Passivierung kann beispielsweise bei einem Silizium-Drucksensor aus Siliziumnitrid bestehen. Dieses hat einen niedrigen Wasserstoff-Diffusionskoeffizienten und schützt daher das Bauteil gegen Ein- und Ausdiffusion von Protonen, die insbesondere bei permanent anliegender Spannung und hoher Betriebstemperatur zu einer Drift der p-Widerstände und p-Kanal Transistoren führen können. Dieser Effekt ist als NBTI bekannt. Um jede Art von mechanischer Verspannung zu vermeiden, wird kein Feldoxid oder ähnliches in der Nähe von mechanischen Bauteilen oder gar auf diesen gefertigt. Daher ist insbesondere die Membrane des beispielhaften Drucksensors nur mit dem Gate-Oxid und der Passivierungsschicht Siliziumnitrid - bedeckt. Des Weiteren werden die Zuleitungen auf dem Die möglichst nicht in Metall, was einen hohen thermischen Ausdehnungskoeffizienten insbesondere gegenüber Silizium hat, sondern im Wafer-Material, im Falle von Silizium als hochdotierte Schicht oder als hochdotiertes Poly-Silizium oder, wenn nicht anders möglich, als hochdotiertes amorphes oder polykristallines Silizium ausgeführt. Die Drain- und Source-Zuleitungen der Transistoren 26,28,35,36 sind in diesem Beispiel (Fig. 14) zum Beispiel als p+ Implantationen 36,35,26,28 ausgeführt. Die Gates und deren Zuleitungen werden beispielhaft in Poly-Silizium ausgeführt 33,39,31 und 32,34,38. In der Fläche 40, die n- dotiert wird, bildet sich aufgrund der Feldschwelle in dem Beispiel kein Kanal aus. Dies ist lediglich an der Kante der Poly-Gates möglich. Deshalb wird ein n+ Channel-Stopper 37 implantiert, der parasitäre Kanäle unterbricht. Durch diese beispielhafte Ganz-Silizium Ausführung ist es somit möglich, das gegen mechanischen Stress sensible Element sehr klein und unempfindlich gegen Fertigungstoleranzen und thermomechanischen Stress durch Fremdmaterialien zu bauen, was die Empfindlichkeit gegen inhomogene Stressverteilungen weiter verringert. Trotz dieser Bemühungen bestehen noch marginale Unterschiede zwischen den Materialien. Daher wird, bei der Auslegung der elektronischen Bauteile auf dem Die und insbesondere bei denen, die sich auf der Membrane befinden, auf die Einhaltung der größten möglichen Symmetrie geachtet. Daher ist es sinnvoll Bauteile, die zu einer Differenzbildung verwendet werden - zum Beispiel solche in Wheatstone-Brücken oder Differenzverstärkern - möglichst nahe beieinander zu platzieren, um den Einfluss von Fertigungsinhomogenitäten zu minimieren.

Fig. 15 zeigt eine weitere Ausprägung der Wheatstone-Brücke. Hierbei wird die Referenzspannung, mit der die Brücke bestehend aus den Transistoren 31,32,33,34 betrieben wird, aus einer dieser gleichenden Brücke, bestehend aus den Transistoren 30,29,55,56, generiert. Zweckmäßigerweise wird hierbei das gleiche Layout-Modul verwandt. Die Referenzbrücke wird kurzgeschlossen und somit die Referenzspannung 35 erzeugt, mit der die Transistoren 31,32,33,34 der ersten Brücke angesteuert werden. Die zweite Brücke wird auf dem Substrat soweit fernab der mechanischen Spannungen wie möglich aber immer noch so nah wie möglich an der ersten Brücke platziert. Letzteres dient dazu, die Fertigungsschwankungen zwischen den beiden Brücken gering zu halten. Die erste Brücke wird in den Punkt geeigneten mechanischen Stresses platziert. Dies ist der Punkt, an dem ein möglichst hoher mechanischer Stress bei Auslenkung der beispielhaften Membrane entsteht, dieser Stress aber noch so homogen ist, dass Fertigungsschwankungen sich nicht zu stark bemerkbar machen können.

Um Dejustage-Einflüsse weiter zu minimieren, kann es sinnvoll sein, mehrere Brücken auf einen Die zu platzieren, Dies kann beispielsweise durch eine Platzierung wie in Fig. 16 gezeigt geschehen. Hier ist die mögliche Platzierung von vier Brücken gemäß Fig. 12 gezeigt. Fig. 17 zeigt die Platzierung der Brücken und Referenzbrücken gemäß Fig.15. Bei einer Anordnung gemäß Fig. 17 entstehen drei Ebenen der Kompensation. In der ersten Ebene, der der vier Transistoren, wird die Richtung des mechanischen Stresses erfasst. Dies geschieht durch Vergleich der Werte von senkrecht zueinander liegenden Transistoren. In der nächsten Ebene werden diese vier Transistoren in ihrer Gesamtheit 43 mit vier weiteren, gleich angeordneten Transistoren 58 verglichen, die nahe bei den ersten vier 43, jedoch in einem mechanisch weniger belasteten Gebiet, idealer Weise auf der neutralen Faser liegen. Hierdurch wird der mechanisch bedingte Offset der Brücke von dem durch Justierfehler während der Fertigung unterschieden. Ist der Sensor symmetrisch, so ist es sinnvoll, entsprechend der Zähligkeit der Symmetrieachse weitere acht Transistoren einzubauen. Im Beispiel (Fig. 17) sind dies vier Paare von Sensoren 44,57;41,60;42,59;43,58, jedes Paar bestehend aus je zwei mal vier Transistoren.

Theoretisch reicht die Platzierung eines einzelnen Transistors bereits für die Stressmessung aus. In diesem Fall, wirken sich allerdings alle Fertigungsfehler bereits massiv aus.

Eine erste alternative Layout-Anordnung ist in Fig. 34 dargestellt. Fig. 33 zeigt die zugehörige Verschaltung mit einer Referenzspannungsquelle bestehen aus den Transistoren 108,109. Hier besitzen die vier zu einer Wheatstone-Brücke verschalteten Transistoren 104,105,106,107 ein gemeinsames Gate 110, was das Layout vereinfacht. Die Brücke wird über die Klemmen 103 und 102 mit Spannung versorgt. Bei mechanischer Verspannung der Brücke tritt eine elektrische Spannung an den Klemmen 111,112 auf. Fig. 35 zeigt eine weitere Ausprägung dieser Brücke. Wird der Channel-Stopper 37 in der Mitte der Brücke weggelassen, so ergibt sich ein Feldplatten ähnlicher Transistor 115 mit vier Anschlüssen. (Fig. 37) Das Ersatzschaltbild des Transistors 115 zeigt Fig. 36. Es kommen dann die Transistoren 114 und 113 hinzu, die zum einen den Stromverbrauch anheben 114 und zum anderen die Signalhöhe verringern 113. Dafür kann aber die Bauform und damit der Flächenbedarf minimiert werden, was in manchen Applikationen sehr nützlich ist.

Eine alternative Layout-Anordnung der Transistoren eines Sensorelementes 41,42,43,44,57,58,59,60 ist in Fig. 18 dargestellt. Hier sind die vier Transistoren 44,45,46,47 sternförmig angeordnet. Sie besitzen einen gemeinsamen Drain-Kontakt 50, der über eine Zuleitung 49 mit einer Stromquelle verbunden ist, die sich nicht auf der Membrane des Drucksensors befindet. Die Gates der Transistoren 44,45,46,47 sind mit einer Poly-Leitung 48 angeschlossen. Die Source-Kontakte werden jeweils mit einer hochdotierten p+ Leitung 51,52,53,54 angeschlossen. Die vier Transistoren sind beispielsweise Teile eines Differenzverstärkers, wie ihn Fig. 19 zeigt. Alle anderen Transistoren der Fig. 19 befinden sich nicht auf der Membrane sondern dem Substrat ohne darunterliegende Kavität. Es ist offensichtlich, dass die Hälfte der vier Transistoren, also beispielsweise die Transistoren 45 und 44 bereits ausreichen würden, einen Differenzverstärker zu bilden. Aus Symmetriegründen ist jedoch die Variante mit vier Transistoren sinnvoll.

Die Schaltung besteht aus zwei Differenzverstärkern. Der linke (Transistoren 65 bis 73) ist im Ausgang und Eingang kurzgeschlossen und arbeitet als Referenzspannungsquelle für den Betrieb des zweiten. Diese Transistoren liegen in einem Gebiet frei von mechanischem Stress. Die zuvor besprochenen Transistoren 44,45,46,47 bilden die Differenzstufe mit den jeweils zugehörigen "Arbeitswiderständen" 61,62,63,64. Die Stromquelle 74 bestromt den so gebildeten Differenzverstärker. Der Transistor 74 ist in diesem Beispiel ein n-Kanal-Transistor. Die Ausgänge des Differenzverstärkers 77,78 spiegeln im Betrieb eine Unsymmetrierung der Transistoren 44,45,46,47 infolge mechanischen Stresses wider. Da die Transistoren 46 und 44 anders als die Transistoren 45 und 47 orientiert sind, führt ein uniaxialer mechanischer Stress zu einem Ausgangssignal an 77,78. Der Differenzverstärker wird in diesem Beispiel durch einen gleich aufgebauten kurzgeschlossenen Referenzdifferenzverstärker in den Arbeitspunkt gebracht. Dieser und die Transistoren 61,62,63,64,74 befinden sich zweckmäßigerweise nicht auf der Membrane sondern in einem Bereich des Die, der nahezu frei von mechanischem Stress ist. Um die Übereinstimmung der elektrischen Parameter der Bauteile in stressfreiem Zustand zu gewährleisten, sollten diese trotzdem so nahe wie möglich bei den anderen Transistoren platziert werden. Zweckmäßigerweise wird daher die Ausrichtung und das Layout aller Elemente möglichst nahe beieinander in gleicher Ausrichtung und gleichem Layout durchgeführt, damit insbesondere auch die Stromspiegelpaare gut aufeinander abgestimmt sind.

Die Fign. 20 bis 25 zeigen unterschiedliche Ausführungen der Gräben und Kavitäten.

Bei der Konstruktion des Race-Tracks 6 und der Kavität 3 müssen verschiedene Faktoren einbezogen werden:
1. Es ist ein geeigneter Abstand zwischen Race-Track-Außenwand und Kavitätswand einzuhalten.
2. Der Kreis, der durch die äußeren Berührungspunkte der Stege mit der Race-Track-Außenwand geht, darf durch die Race-Track-Außenwand nicht geschnitten werden, da dies eine Verzerrung des mechanischen Stress-Feldes im Boss 12 zur Folge hätte.
3. Die Verbindungslinien zwischen den Fußpunkten der Stege 8 am Boss 12 darf nicht durch die Außenkante des Bosses geschnitten werden, da dies eine Verzerrung des mechanischen Stress-Feldes im Boss zur Folge hätte.
4. Die Konstruktion sollte möglichst keine Ecken aufweisen, da in diesen sehr starke Spannungen auftreten können, die zu nichtlinearen Effekten und Bistabilität führen können.

Dem entgegen stehen Anforderungen hinsichtlich des Berst-Druckes. Wird die Race-Track-Fläche zu groß, so bricht die Race-Track-Membrane schneller.

Zur Entkoppelung der Membrane von mechanischem Stress, der durch die Aufbau und Verbindungstechnik hervorgerufen wird, ist es daher beispielsweise sinnvoll, einen weiteren Graben 93 um den Sensor herum zu fertigen. (Fig. 26) und so eine virtuell größere Race-Track-Membrane ohne die angesprochene Bruchgefahr herzustellen.

Hierbei ist der Sensor an Stegen 94 aufgehängt. Diese stellen im Idealfall keine Verlängerung der Stege 8 dar, an denen der Boss 12 befestigt ist. Hierdurch wird mechanischer Stress nur indirekt von außen auf die Sensoren 9 übertragen.

Dieses Prinzip kann weiter durch einen weiteren Graben 95 und weitere Stege 96 fortgesetzt werden (Fig. 27).

Die Konstruktion unter Zuhilfenahme eines Bosses führt zu einer erhöhten Empfindlichkeit gegen seismische Belastungen. Diese Empfindlichkeit kann durch Reduktion der Boss-Masse gesenkt werden (Fig. 28), Hierbei wird in dem Boss 97 ein geeignetes Tragwerk geätzt. Es bleiben Stege stehe, die bei geeigneter Wahl ein ausreichendes Flächenträgheitsmoment erzeugen, um die mechanische Stabilität zu gewährleisten. Der Sensor 22 wird dabei wie zuvor auf einem Steg 20, der den Race-Track-Graben 19 unterbricht, platziert.

Soll statt eines Absolutdrucksensors ein Differenzdrucksensor hergestellt werden, so kann dies durch nachträgliche Ätzung einer Öffnung 119 in den unteren Wafer geschehen. Die Fign, 29 und 30 zeigen entsprechende beispielhafte Ausformungen. Der Vorteil einer solchen Konstruktion liegt in der kleinen Öffnung und damit in dem nur sehr geringen Verlust an Stabilität gegenüber einem Sensor, bei dem die Kavität von der Rückseite her geätzt wurde.

Das Bondsystem besteht in der Regel aus Metall mit einem erheblich abweichenden thermischen Ausdehnungskoeffizienten. Des Weiteren führt das Metall zu Hysterese-Effekten. Daher ist es sinnvoll die Bond-Pads 10 soweit wie möglich vom Rest der Sensoren zu entkoppeln. Dies kann durch mechanische Guard-Ringe in Form von Gräben 157 geschehen, die beispielsweise soweit wie möglich um die Pads oder zu schützende Teile herum gelegt werden (Fig. 32).

Anhand der Fig. 39 wird nachfolgend nochmals auf das Ausführungsbeispiel eines mikroelektromechanischen Halbleiterbauelements mit Boss-reduzierter Masse eingegangen. Die Herstellung des in Fig. 39 gezeigten Halbleiterbauelements ist wie folgt. In einem Handle-Wafer 16 ist eine Kavität 18 geätzt, die durch Seitenwände 18a und eine Bodenwand 18b begrenzt ist. Der HandleWafer 16 ist über eine Oxid-Schicht 17 mit einer Poly-Silizium-Lage 15 verbunden, die wiederum über eine Oxid-Schicht 14 von einem Device-Wafer 13 getrennt ist. Der Device-Wafer 13 dient innerhalb seines die Kavität 18 überspannenden Bereichs als Deckwand 18c, die die Kavität 18 begrenzt. Auf dem Device-Wafer 13 wurden in einem CMOS-Prozess elektronische Bauteile (beispielsweise piezoresistive Transistoren oder Widerstände) 22, Leitungen 24 und Anschlüsse 23 hergestellt. Anschließend wurden die mechanischen Eigenschaften der Membran 25 (d.h. der flexiblen Deckwand 18c) oberhalb der Kavität 18 durch Ätzen von Gräben 19 und Stehenlassen von Biegestegen 20 gezielt verändert. Dabei verlaufen die Gräben 19 einwärts versetzt zu den Seitenwänden 18a und umgeben einen zentralen Bereich 21 der Membran 25 bzw. der Deckwand 18c. Hierbei bleibt zunächst in der Mitte ein in seiner Dicke unveränderter Bereich 21 zurück (der sogenannte Boss). Dieser besitzt eine erhöhte Masse, was bezüglich der seismischen Sensitivität von Nachteil ist. Bei der erfindungsgemäßen Vorrichtung wird dieser Boss durch eine Strukturierung 97 so verändert, dass sich die mechanische Stabilität des zentralen Bereichs 21 nicht wesentlich ändert, seine Masse aber wesentlich vermindert ist. Dies geschieht durch Ätzen von Vertiefungen 97a und Stehenlassen von Versteifungsstreben 97b. Die Vertiefungen 97a werden wie die Gräben 19 von einer Seite aus in den Device-Wafer 13 durch zwei Ätzschritte hinein geätzt. Beim ersten Ätzschritt wird ein Graben in das Silizium des Device-Wafer 13 geätzt, wobei die darunterliegende Siliziumoxid-Schicht 14 als Ätzstopp dienen kann. Dann wird in einem zweiten Ätzschritt das Siliziumoxid der Schicht 14 geätzt, wobei die Poly-Silizium-Lage 15 als Ätzstopp wirken kann.

Bei dieser Gelegenheit sei darauf hingewiesen, dass die Erfindung nicht auf die Konstruktion und Herstellung gemäß Fig. 39 beschränkt ist. So können für das mikroelektromechanische Halbleiterbauelement auch Strukturen verwendet werden, wie sie vorstehend anhand der Fign. 1 bis 10 gezeigt und erläutert sind.

Weitere Eigenschaften der Erfindung und einer beispielhaften Anwendung lassen sich wie folgt beschreiben:
1. Fotolithografisch gefertigter Transistor auf einem dotierten Substrat oder in einer dotierten Wanne, wobei
   i. der Transistor nur mit Materialien elektrisch verbunden ist, die einen ähnlichen mechanischen Ausdehnungskoeffizienten haben wie das Substrat oder die Wanne, in der er platziert ist, haben,
   ii. der Transistor nicht oder nur in sehr geringer mechanischer Verbindung mit anderen Materialien insbesondere solchen Materialien mit anderen mechanischen Eigenschaften als das Substrat oder die Wanne - hierbei insbesondere Feldoxiden - steht,
   iii. der Transistor Symmetrien aufweist,
   iv. der Transistor durch Lithografie verschiedener geometrischer, aufeinander abgestimmter Strukturen in verschiedenen Prozessschritten gefertigt wird, und
   v. diese geometrischen Strukturen, deren Überlagerung und Zusammenwirken im Fertigungsprozess den Transistor ergibt, so gewählt sind, dass Prozessschwankungen innerhalb der Prozessspezifikationsgrenzen die Änderungen der Geometrien der einzelnen Lithografieschritt-Ergebnisse in Form gefertigter geometrischer Strukturen keine oder nur sehr geringe Auswirkung auf die elektrischen und / oder mechanischen Eigenschaften des Transistors haben.
2. Transistor nach Ziff. 1, bei dem es sich um einen MOS-Transistor handelt.
3. MOS Transistor zur Detektion von mechanischem Stress, der über vier Kanal-Anschlüsse verfügt.
4. MOS Transistor nach Ziff. 3, der eine vierzählige Rotationssymmetrie und eine Gate-Platte mit eben dieser Symmetrie und Kanalanschlüsse in einer Anordnung mit eben dieser Symmetrie aufweist, ohne eine Symmetrie der Anschlüsse dieser Gate-Platte aufweisen zu müssen.
5. Transistor nach Ziff. 1, bei dem es sich um einen Bipolar Transistor handelt.
6. Transistor nach Ziff. 1 bis 4, der über einen Channel-Stopper verfügt.
7. Transistor nach Ziff. 1 bis 4, dessen Source und/oder Drain-Gebiete durch eine hochdotiertes Gebiet oder niederohmiges Poly-Silizium elektrisch angeschlossen sind.
8. Transistor nach Ziff 1 bis 7, der zur Detektion von mechanischem Stress verwendet wird.
9. Transistor nach Ziff. 1 bis 8, der wie ein elektrischer Widerstand insbesondere in einer Messbrücke genutzt wird.
10. Transistor nach Ziff. 1 bis 9, der ein pnp-Transistor ist.
11. Transistor nach Ziff. 1 bis 9, der ein npn-Transistor ist.
12. Transistor nach Ziff. 1 bis 9, der ein p-Kanal Transistor ist.
13. Transistor nach Ziff. 1 bis 9, der ein n-Kanal Transistor ist.
14. Elektronische Schaltung, die Transistoren nach einem oder mehreren der Ziff. 1 bis 13 enthält.
15. Elektronische Schaltung, die in einem funktionalen Zusammenhang mit einer mikromechanischen Vorrichtung gemäß Ziff. 41 steht.
16. Schaltung nach Ziff. 14 oder 15, die diskrete und/oder integrierte elektronische Bauelemente enthält.
17. Schaltung nach Ziff. 14 bis 16, die zumindest teilweise durch monolithische Integration gefertigt ist.
18. Schaltung nach Ziff. 14 bis 17, die mindestens zwei geometrisch gleich konstruierte Transistoren nach Ziff. 1 bis 13 enthält.
19. Schaltung nach Ziff. 18, die ein Signal erzeugt, das zur Messung eines unterschiedlichen Zustands in mindestens einem physikalischen Parameter der beiden Transistoren geeignet ist.
20. Schaltung nach Ziff. 19, bei der es sich bei dem physikalischen Parameter um mechanischen Stress und/oder Temperatur handelt.
21. Schaltung nach Ziff. 18 bis 20, bei der mindestens zwei der Transistoren nach Ziff. 1 bis 13 ohne Betrachtung der Anschlussleitungen zueinander symmetrisch angeordnet sind.
22. Schaltung nach Ziff. 18 bis 20, bei der für mindestens zwei der Transistoren nach einem oder mehreren der Ziff. 1 bis 13 gilt, dass ihre Geometrie ohne Betrachtung der Anschlussleitungen durch Rotation um 90° zueinander in Deckung gebracht werden kann.
23. Schaltung nach Ziff. 14 bis 22, die mindestens vier Transistoren nach Ziff. 1 bis 13 enthält.
24. Schaltung nach Ziff. 23, bei der die vier Transistoren zu einer Messbrücke verschaltet sind.
25. Schaltung nach Ziff. 24, bei der Gate und Source mindestens eines Transistors nach Ziff. 1 bis 13 kurzgeschlossen sind.
26. Schaltung nach Ziff. 24 oder 25, bei der das Gate mindestens eines der Transistoren nach Ziff. 1 bis 13 mit einer Referenzspannungsquelle verbunden ist.
27. Schaltung nach Ziff. 26, bei der die Referenzspannungsquelle eine zweite, jedoch kurzgeschlossene Messbrücke nach Ziff. 24 bis 27 ist.
28. Schaltung nach Ziff. 27, bei der die zweite Messbrücke der ersten Messbrücke gleicht und zwar insbesondere in der Dimensionierung der Transistoren und/oder der Verschaltung und/oder der gefertigten Geometrie und/oder im Extremfall eine geometrische Kopie der ersten Messbrücke ist.
29. Schaltung nach Ziff. 14 bis 28, bei der jeweils zwei der vier Transistoren bei gleicher Geometrie gleich ausgerichtet sind.
30. Schaltung nach Ziff. 29, bei der die Transistoren des einen Transistorpaares senkrecht zum anderen Transistorpaar orientiert sind.
31. Schaltung nach Ziff. 30, bei der die vier Transistoren in einem Viereck symmetrisch angeordnet sind.
32. Schaltung nach Ziff. 30, bei der die vier Transistoren in einem Kreuz symmetrisch angeordnet sind.
33. Schaltung nach Ziff. 14 bis 23 oder 29 bis 32, die mindestens eine Differenzverstärkerschaltung enthält.
34. Schaltung nach Ziff. 33, bei der mindestens einer der Transistoren mindestens eines Differenzverstärkers ein Transistor gemäß Ziff. 1 bis 13 ist.
35. Schaltung nach Ziff. 33 oder 34, die mindestens eine Referenzspannungsquelle enthält, die mit mindestens einem ersten Differenzverstärker gekoppelt ist.
36. Schaltung nach Ziff. 35, bei der die Referenzspannungsquelle ein zweiter, jedoch kurzgeschlossener Differenzverstärker ist, der ein Differenzverstärker nach Ziff. 33 bis 35 ist.
37. Schaltung nach Ziff. 36, bei der der zweite Differenzverstärker dem ersten Differenzverstärker gleicht und zwar insbesondere in der Dimensionierung der Transistoren und/oder der Verschaltung der Transistoren und/oder der gefertigten Geometrie der Transistoren und/oder im Extremfall eine geometrische Kopie des ersten Differenzverstärkers ist.
38. Schaltung nach Ziff. 14 bis 37, bei der zumindest ein Teil derselben gleichzeitig Teil einer mikromechanischen Vorrichtung ist.
39. Schaltung nach Ziff. 38, bei der mindestens ein Teil der Schaltung mit mindestens einem mikromechanischen Funktionselement dergestalt funktionell verbunden ist, dass mindestens ein mechanischer Parameter mindestens eines mikromechanischen Funktionselementes mit der Zustandsfunktion der Schaltung oder mit mindestens einem elektrischen Parameter der Zustandsfunktion mindestens eines Schaltungsteils verkoppelt ist.
40. Schaltung nach Ziff. 39, wobei es sich bei dem Funktionselement insbesondere um einen Balken oder Steg, eine Membrane, einen Resonator, eine einseitig oder zweiseitig oder dreiseitig eingespannte Lippe, eine Blende, eine Nadel handelt.
41. Mikromechanische Vorrichtung, die durch lithographische Prozesse und Verbindung, insbesondere Bondung, mindestens zweier Wafer hergestellt wurde, wobei
   I. vor der Verbindung der mindestens zwei Wafer mindestens ein mikromechanisches Funktionselement in Form von mindestens einer Oberflächenstruktur auf mindestens einer Oberfläche mindestens eines der beiden Wafer aufgebracht wurden und
   II. mindestens eines der so gefertigten mikromechanischen Funktionselemente bzw. Oberflächenstrukturen nach der Verbindung der Wafer in der Nähe der Grenzfläche zwischen diesen innerhalb des sich ergebenden Wafer-Paketes liegt und
   III. auf mindestens einer Oberfläche des sich ergebenden Wafer-Paketes im Anschluss an die Verbindung der Wafer mindestens ein Prozess zur Herstellung von elektronischen Bauelementen zur Herstellung mindestens eines elektronischen Bauelements durchgeführt wurde und
   IV. mindestens eines der so hergestellten elektronischen Bauelemente gegen mindestens eine nicht elektrische physikalische Größe empfindlich ist und diese erfassen soll und
   V. dieses Bauelement selbstjustierend hergestellt wird.
42. Mikromechanische Vorrichtung gemäß Ziff. 41, bei der mindestens eines der selbstjustierenden Bauelemente ein Transistor gemäß Ziff. 1 bis 10 ist oder Teil einer Schaltung gemäß Ziff. 14 bis 40 ist.
43. Mikromechanische Vorrichtung gemäß Ziff. 41 oder 42, die aus Silizium hergestellt ist.
44. Mikromechanische Vorrichtung gemäß Ziff. 41 bis 43, bei der es sich bei mindestens einem mikromechanischen Funktionselement um mindestens eine Kavität handelt.
45. Mikromechanische Vorrichtung gemäß Ziff. 44, bei der mindestens eine Kavität mit mindestens einer Oberfläche des Wafer-Paketes eine Membrane definiert.
46. Mikromechanische Vorrichtung gemäß Ziff. 44 und 45, wobei mindestens eine Kavität keine Oxide an ihren Wänden aufweist.
47. Mikromechanische Vorrichtung nach Ziff. 41 bis 46, wobei sich mindestens ein mikromechanisches Funktionselement auf der Oberfläche der Vorrichtung befindet.
48. Mikromechanische Vorrichtung nach Ziff. 47, wobei es sich bei mindestens einem mikromechanischen Funktionselement um einen Steg, einen Graben, eine Membrane, einen Durchbruch und eine vergrabene Kavität oder ein Sack-Loch handelt.
49. Mikromechanische Vorrichtung nach Ziff. 38, bei der mindestens ein mikromechanisches Funktionselement an der Oberfläche nach Durchführung eines Prozesses, insbesondere eines CMOS Prozesses, zur Fertigung eines Transistors nach Ziff. 1 bis 13 oder einer Schaltung nach Ziff. 14 bis 40 gefertigt wurde.
50. Mikromechanische Vorrichtung gemäß Ziff. 41 bis 49, bei der mindestens ein mikromechanisches Funktionselement unter anderem durch Verwendung von DRIE- oder Plasma-Ätzprozessen hergestellt wurde.
51. Mikromechanische Vorrichtung gemäß Ziff. 41 bis 50, die als Drucksensor benutzt werden kann.
52. Mikromechanische Vorrichtung gemäß Ziff. 44 bis 51, bei der die geometrische Form mindestens einer Kavität bezüglich der Verbindungsebene der Wafer Symmetrien aufweist.
53. Mikromechanische Vorrichtung nach Ziff. 41 bis 52, wobei auf mindestens einer Oberfläche des Wafer-Paketes die Gräben durch DRIE- oder Plasma-Ätzung hergestellt sind.
54. Mikromechanische Vorrichtung nach Ziff. 53, bei der mindestens eine Teilmenge der Gräben eine geschlossene Struktur, beispielsweise einen Ring, eine Ellipse, ein Viereck, einen Stern oder ähnliches bilden, die nur an wenigen Stellen durch dünne Stege 8,20 unterbrochen sind.
55. Mikromechanische Vorrichtung nach Ziff. 53 und 54, bei der mindestens ein Teil der Gräben symmetrisch zueinander angeordnet ist.
56. Mikromechanische Vorrichtung nach Ziff. 52 und 55, bei der Symmetrieachsen eines Teils der Gräben und mindestens einer Kavität zusammenfallen bzw. bei idealer Anfertigung zusammenfallen.
57. Mikromechanische Vorrichtung nach Ziff. 52, 55 und 56, bei der mindestens einer der Gräben in einem mechanischen Funktionszusammenhang mit mindestens einer Kavität steht.
58. Mikromechanische Vorrichtung nach Ziff. 57, bei der der Boden mindestens einer der Gräben mit mindestens einer der Kavitäten eine Membranverdünnung oder eine Öffnung in diese Kavität hinein ergibt.
59. Mikromechanische Vorrichtung nach Ziff. 41 bis 58, bei der mikromechanische Funktionselemente der Oberseite, insbesondere die in Ziff. 47 bis 58 erwähnten Gräben, mit ihren ihre Form definierenden Kanten nicht über Form definierenden Kanten von mikromechanischen Strukturen der Unterseite und mikromechanischen Strukturen der Oberseite liegen.
60. Mikromechanische Vorrichtung nach Ziff. 59, bei der die Hebellänge 116 zwischen dem Ansatzpunkt einer unterhalb liegenden Struktur 121, insbesondere einer vergrabenen Kavität 4, und der Ansatzpunkt einer oberhalb liegenden Struktur 119, insbesondere eines Grabens 6, größer ist als das kleinere der vertikalen Hebelmaße 118 und 120 (siehe Fig. 38).
61. Mikromechanische Vorrichtung nach Ziff. 44 bis 60, bei der sich innerhalb des Körpers der mikromechanischen Vorrichtung, insbesondere während der Fertigung derselben innerhalb des Wafer-Paketes, mindestens eine Kavität befindet, die mit der Unterseite oder Oberseite des Wafer-Paketes durch mindestens ein mikromechanisches Funktionselement, insbesondere eine Röhre, in Verbindung steht.
62. Mikromechanische Vorrichtung nach Ziff. 61, die als Differenzdrucksensor gegen einen definierten Referenzdruck oder Umgebungsdruck eingesetzt werden kann.
63. Mikromechanische Vorrichtung nach Ziff. 61 und 62, die mindestens ein mikrofluidisches Funktionselement besitzt.
64. Mikromechanische Vorrichtung nach Ziff. 63, bei der mindestens ein mikrofluidisches Funktionselement zur Zuführung von Medien wie Flüssigkeiten und Gasen dient oder dienen kann.
65. Mikromechanische Vorrichtung, bei der mindestens ein mikrofluidisches Funktionselement nach Ziff. 63 bis 64 oder ein mikromechanische Funktionselement nach Ziff. 61 nach Durchführung eines Prozesses, insbesondere eines CMOS Prozesses, zur Fertigung eines Transistors nach Ziff. 1 bis 13 oder einer Schaltung nach Ziff. 14 bis 40 gefertigt wurde.
66. Mikromechanische Vorrichtung nach Ziff. 1 bis 65, bei der mindestens als ein Teilsubstrat oder Substrat ein p-dotiertes Halbleitermaterial verwendet wurde.
67. Mikromechanische Vorrichtung nach Ziff. 1 bis 65, bei der mindestens als ein Teilsubstrat oder Substrat ein n-dotiertes Halbleitermaterial verwendet wurde.
68. Mikromechanische Vorrichtung nach Ziff. 44 bis 67, bei der in mindestens einem Substrat eine Materialmodifikation, beispielsweise eine SiO₂-Schicht, vorliegt, die als Ätzstopp für das Ätzen mindestens einer Kavität dient.
69. Mikromechanische Vorrichtung nach Ziff. 53 bis 68, bei der in mindestens einem Substrat eine Materialmodifikation 14 vorliegt, die als Ätzstopp für das Ätzen mindestens eines Teils der Gräben dient.
70. Mikromechanische Vorrichtung nach Ziff. 69, bei der in mindestens einem Substrat mindestens eine Materialmodifikation 15 vorliegt, die als Membrane im Bereich der Gräben wirkt.
71. Mikromechanische Vorrichtung nach Ziff. 70, bei der mindestens eine Materialmodifikation 15 aus Poly-Silizium und/ oder amorphen Silizium ist und auf einem der Wafer des Wafer-Paketes vor dem Wafer-Bonden abgeschieden wurde.
72. Mikromechanische Vorrichtung nach Ziff. 44 bis 67 und 69 bis 71, bei der mindestens eine Kavität zeitkontrolliert in mindestens ein Substrat geätzt wurde.
73. Mikromechanische Vorrichtung nach Ziff. 53 bis 68 und 70, bei der mindestens ein Teil der Gräben zeitkontrolliert in das Substrat geätzt wurden.
74. Mikromechanische Vorrichtung nach Ziff. 53 bis 73, wobei vor Ätzung der Gräben ein Halbleiterprozess zur Herstellung elektrischer Funktionselemente auf mindestens einer Oberfläche des Wafer-Paketes durchgeführt wurde.
75. Mikromechanische Vorrichtung nach Ziff. 74, die mindestens ein elektrisches Funktionselement aufweist, das in dem Prozess gemäß Ziff. 74 gefertigt wurde.
76. Mikromechanische Vorrichtung nach Ziff. 75, bei der mindestens ein elektrisches Funktionselement die Funktion einer elektrischen Leitung oder eines Kontaktes oder einer Durchkontaktierung oder einer elektrischen Leitungsisolation oder eines Widerstands oder eines Transistors oder einer Diode oder eines Kondensators oder einer Spule hat.
77. Mikromechanische Vorrichtung nach Ziff. 76, bei der mindestens eines der Funktionselemente mindestens einen Parameter - insbesondere elektrischen Parameter - in Abhängigkeit von mechanischen Größen, insbesondere Zug-, Druck- und Schubspannung, ändert.
78. Mikromechanische Vorrichtung nach Ziff. 77, wobei diese Parameteränderung außerhalb des Sensors gemessen werden kann.
79. Mikromechanische Vorrichtung nach Ziff. 77 und 54, bei der mindestens eines der Funktionselemente in einem mechanischen Funktionszusammenhang mit mindestens einem Steg 8,20 steht.
80. Mikromechanische Vorrichtung nach Ziff. 77 und 36, bei der mindestens ein elektronisches Funktionselement so gegenüber
   a) mindestens einem ersten mikromechanischen Funktionselement, insbesondere einer Membrane (12 oder 21),
   b) mindestens zwei weiteren, zweiten mikromechanischen Funktionselementen, insbesondere Gräben (6 oder 19), und
   c) mindestens einem dritten mikromechanischen Funktionselement, insbesondere einem Steg (8 oder 20),
   wobei die Funktionselemente gemäß a) bis c) in einem mechanischen funktionalen Zusammenhang stehen, auf dem dritten mikromechanischen Funktionselement, insbesondere Steg, positioniert ist, dass es in oder nahe dem Punkt größter mechanischer Spannung liegt, wenn das erste mikromechanische Funktionselement, insbesondere eine Membrane oder eine Inertialmasse (12 oder 21), verformt, insbesondere ausgelenkt, wird.
81. Mikromechanische Vorrichtung gemäß Ziff. 80, bei der mindestens ein drittes mikromechanische Funktionselement, insbesondere ein Steg so geformt ist, dass dieses über einen Bereich hoher homogenisierter mechanischer Spannung im Fall der Verformung des ersten mikromechanischen Funktionselementes, insbesondere einer Membrane oder Inertialmasse, verfügt.
82. Mikromechanische Vorrichtung gemäß Ziff. 81, bei der sich mindestens ein elektronisches Funktionselements an mindestens einem besagten Platz hoher homogenisierter mechanischer Spannung befindet.
83. Mikromechanische Vorrichtung nach Ziff. 41 bis 82, bei der mindestens zwei Wafer unterschiedlich dick ausgeführt wurden.
84. Mikromechanische Vorrichtung nach Ziff. 41 bis 82, wobei es sich bei einem Wafer-Material um Silizium oder SOI Material handelt.
85. Mikromechanische Vorrichtung nach Ziff. 44 bis 79, wobei die Kavität vor dem Bonden dreier Wafer in dem untersten Wafer hergestellt wird.
86. Mikromechanische Vorrichtung nach Ziff. 86, wobei die drei Wafer unterschiedlich dick ausgeführt wurden.
87. Mikromechanische Vorrichtung nach Ziff. 53 bis 86, wobei es sich bei mindestens einem der zweiten mikromechanischen Funktionselemente um einen Graben (6 oder 19) handelt, dessen Breite nicht konstant ist.
88. Mikromechanische Vorrichtung nach Ziff. 54 bis 87, bei der mindestens ein Steg einen Graben (6 oder 19) nicht teilt, sondern nur in diesen hineinragt (z.B. Fig. 25).
89. Mikromechanische Vorrichtung nach Ziff. 54 bis 88, bei der zwischen den Stegen und Gräben eine Fläche auf einer Membrane entsteht, die an den Stegen hängend, viereckig (z.B. Fig. 20 oder 23), rautenförmig (z.B. Fig. 21 oder Fig. 22) oder rund (z.B. Fig. 24) ist.
90. Mikromechanische Vorrichtung nach Ziff. 89, wobei mindestens ein Graben keinen Boden hat und daher mit mindestens einer Kavität verbunden ist.
91. Mikromechanische Vorrichtung gemäß Ziff. 41 bis 90, die als Drucksensor und/oder Beschleunigungssensor verwendet werden kann.
92. Mikromechanische Vorrichtung gemäß Ziff. 41 bis 91, die symmetrisch angeordnete mechanische erste Funktionselemente, insbesondere Stege, aufweist, die mit mindestens einem weiteren zweiten mikromechanischen Funktionselement, insbesondere einer Membrane oder Inertialmasse verbunden sind und auf denen sich jeweils sich gleichende Schaltungsteile einer Schaltung gemäß Ziff. 14 bis 40 befinden.
93. Mikromechanische Vorrichtung und Schaltung gemäß Ziff. 92, wobei die auf den ersten mikromechanischen Funktionselementen befindlichen Schaltungsteile so miteinander elektrisch verbunden sind, dass Mittelwerte und/oder Differenzen gebildet werden.
94. Mikromechanische Vorrichtung gemäß Ziff. 41 bis 93, die mindestens an einer ersten Position ein erstes mechanisches Funktionselement, insbesondere einen Steg, aufweist, der mit mindestens einem weiteren zweiten mikromechanischen Funktionselement, insbesondere einer Membrane mechanisch verbunden ist und eine zweite Position aufweist, die keine mechanische Funktion hat und keinen oder nur geringem mechanischem Einfluss ausgesetzt ist, und dass sich an mindestens die beiden Positionen sich jeweils sich gleichende Schaltungsteile einer Schaltung gemäß Ziff. 14 bis 40 befinden.
95. Mikromechanische Vorrichtung und Schaltung gemäß Ziff. 94, wobei die auf den beiden Positionen befindlichen Schaltungsteile so miteinander elektrisch verbunden sind, dass Mittelwerte und/oder Differenzen gebildet werden.
96. Mikromechanische Vorrichtung und Schaltung gemäß Ziff. 92 bis 95, wobei die mikromechanische Vorrichtung aus mindestens zwei kompletten mikromechanischen Teilvorrichtungen, insbesondere zwei Drucksensoren, gemäß Ziff. 92 bis 95, die wieder in einem funktionalen Zusammenhang stehen.
97. Mikromechanische Vorrichtung und Schaltung gemäß Ziff. 96, wobei innerhalb der Schaltung mathematische Operationen, insbesondere die Bildung von Mittelwerten und Differenzen, auf die elektrischen Ausgangswerte der Teilvorrichtungen angewandt werden.
98. Mikromechanische Vorrichtung und Schaltung gemäß Ziff. 94 bis 97, bei der mindestens ein zweiter Schaltungsteil, der einem ersten Schaltungsteil an der ersten Position, insbesondere auf einem Steg, gleicht, als Referenz, insbesondere Spannungsreferenz, benutzt wird und sich nicht in einem funktionalen Zusammenhang mit einem mikromechanischen Funktionselement befindet.
99. Mikromechanische Vorrichtung und Schaltung gemäß Ziff. 92 bis 98, wobei zu jedem Schaltungsteil auf einer ersten Position mindestens ein Schaltungsteil, der dem Schaltungsteil auf dem jeweiligen Steg gleicht, als Referenz zugeordnet ist und wobei sich diese Referenz nicht in einem funktionalen Zusammenhang mit einem mikromechanischen Funktionselement befindet.
100. Mikromechanische Vorrichtung und Schaltung gemäß Ziff. 99, wobei sich die Referenz auf der neutralen Faser befindet.
101. Mikromechanische Vorrichtung und Schaltung insbesondere nach Ziff. 92 bis 100, bei der mindestens eine Verstärkerschaltung Teil derselben ist.
102. Mikromechanische Vorrichtung und Schaltung insbesondere nach Ziff. 101, wobei die Verstärkerschaltung über einen positiven und negativen Eingang verfügt.
103. Mikromechanische Vorrichtung und Schaltung nach Ziff. 1 bis 201, die in weiten Teilen mit einem Schutz gegen Feuchtigkeit und/ oder Protonen Ein- und Ausdiffusion versehen sind.
104. Mikromechanische Vorrichtung und Schaltung nach Ziff. 103, wobei der Diffusionsschutz aus einer Silizium-Nitrid Schicht besteht.

Weitere Merkmale der Erfindung sind:
1. Verminderung der Anzahl notwendiger Wafer-Bond-Verbindungen
2. Reduktion parasitärer Elemente
   a) Eliminierung von Quellen mechanischen Stresses
   b) Schutz gegen Ausbreitung unvermeidlichen mechanischen Stresses
   c) Maximierung, Homogenisierung und Linearisierung mechanischer Nutz-Stressfeldern
   d) Verminderung der Streuung elektronischer Bauteile
   e) Verminderung der Streuung elektronischer Schaltungen
   f) Verminderung der Streuung mikromechanischer Funktionselemente
3. Erhöhung der Toleranz der Konstruktion gegenüber mechanischen und elektrischen Fertigungsstreuungen
4. Verringerung der Auswirkungen unvermeidlicher parasitärer Elemente
5. Reduktion des Einflusses der Aufbau und Verbindungstechnik
6. Flexibilisierung des Einsatzes der Sensoren durch den Nutzer
7. Verringerung der notwendigen Die-Fläche
8. Möglichkeit der Ankoppelung an hochvolumige Standard-CMOS-Linien insbesondere solche mit p-dotierten Substraten

Diese Eigenschaften werden insbesondere durch die im Folgenden beschriebenen Maßnahmen realisiert, die einzeln oder in Gesamt- oder Teilkombination Anwendung finden können:
1. Verminderung der Anzahl notwendiger Wafer-Bond-Verbindungen durch a) Herstellung von Kavitäten vor der CMOS Prozessierung
2. Reduktion parasitärer Elemente durch
   a) Eliminierung von Quellen mechanischen Stresses insbesondere durch
      i) Vermeidung unnötiger Schichten auf den mikromechanischen Funktionselementen, insbesondere auf Drucksensormembranen
   b) Schutz gegen Ausbreitung unvermeidlichen mechanischen Stresses insbesondere durch
      i) Eindämmung des Stresses mittels mechanischer Guard-Ringe und
      ii) Reduktion der Tiefe von Kavitäten im Material wodurch dieses ein höheres Flächenträgheitsmoment aufweist
   c) Maximierung, Homogenisierung und Linearisierung von Nutz-Stressfeldern insbesondere durch
      i) Einätzung von Gräben in Druckmembranen
      ii) Wahl der Grabenform
      iii) Abstand zwischen Rückseitenstrukturen und vergrabene Strukturen auf der einen Seite und Vorderseitenstrukturen auf der anderen Seite zur Reduktion der Justierfehler
   d) Verminderung der Streuung elektronischer Bauteile durch
      i) Verwendung selbstjustierender Strukturen
   e) Verminderung der Streuung elektronischer Schaltungen durch
      i) Verwendung eines kompakten, symmetrischen selbstjustierenden Spezialtransistors
      ii) Verwendung einer kompakten, symmetrischen, selbstjustierenden Differenzverstärkerstufe
      iii) Verwendung einer kompakten selbstjustierenden, symmetrischen aktiven Wheatstone-Brücke
   f) Verminderung der Streuung mikromechanischer Funktionselemente durch
      i) Verwendung definierter, CMOS-kompatibler Ätzstops
      ii) Verwendung besonders miniaturisierbarer Spezialtransistoren
3. Erhöhung der Toleranz der Konstruktion gegenüber mechanischen und elektrischen Fertigungsstreuungen durch
   a) Unterscheidung der Stress-Richtung
   b) Unterscheidung zwischen gestressten und ungestressten Schaltungsteilen
   c) Unterscheidung zwischen Schaltungsteilen an unterschiedlichen Symmetrie-Positionen
   d) Geeignete kompensierende Verschaltung von Schaltungsteilen, die die Unterscheidungen i bis iii messend erfassen können.
   e) Verwendung besonders miniaturisierbarer selbstjustierender Spezialtransistoren
   f) Minimalisierung des mechanischen Aufbaus durch gezielte Reduktion des Schichtstapels im Bereich mikromechanischer Funktionselemente
4. Verringerung der Auswirkungen unvermeidlicher parasitärer Elemente
   a) Kompensationsschaltungen
   b) Verwendung besonders miniaturisierbarer Spezialtransistoren
5. Reduktion des Einflusses der Aufbau und Verbindungstechnik durch
   a) die Reduktion der Tiefe von Kavitäten im Material, wodurch dieses ein höheres Flächenträgheitsmoment aufweist
   b) Verwendung runder Kavitäten, wodurch das vertikale Flächenträgheitsmoment vergrößert wird
6. Flexibilisierung des Einsatzes der Sensoren durch den Nutzer durch
   a) Einstellbarkeit der Verstärkung durch den Nutzer
7. Verringerung der notwendigen Die-Fläche durch
   a) Reduktion der Tiefe von Kavitäten im Material, wodurch dieses ein höheres Flächenträgheitsmoment aufweist und der Sensor ohne Stabilitätsverlust verkleinert werden kann
   b) Verwendung besonders miniaturisierbarer Spezialtransistoren
   c) Erstellung einer minimalen Zutrittsöffnung für Gase und Flüssigkeiten zu einer vergrabenen Kavität
8. Möglichkeit der Ankoppelung an hochvolumige Standard-CMOS-Linien insbesondere solche mit p-dotierten Substraten durch
   a) Fertigung der Kavitäten mit definiertem Ätzstopp vor dem CMOS-Prozess
   b) Herstellung mikromechanischer Funktionselemente an der Oberfläche wie Gräben nach erfolgter CMOS Prozessierung durch Plasma- oder DRIE Ätzung
   c) Herstellung minimalen Zutrittsöffnungen zu vergrabenen Kavitäten nach erfolgter CMOS Prozessierung

### BEZUGZEICHENLISTE

- 1: Erster Wafer
- 2: Oxid-Schicht
- 3: Gerade Wand der Kavität 4
- 4: Kavität
- 5: Zweiter Wafer
- 6: Gräben im Waferpaket
- 7: Dünne Membranbereiche, die durch die Gräben 6 und die Kavität 4 definiert werden
- 8: Stege, die die Gräben 6 unterbrechen
- 9: Bauteile zur Erfassung des mechanischen Stresses
- 10: Anschlüsse mit Anschlussleitungen
- 11: Oberfläche des Waferpaketes
- 12: Zentral-Platte der Membrane
- 13: Erster Wafer
- 14: SiO2 Schicht
- 15: Poly-Silizium Schicht
- 16: Zweiter Wafer
- 17: Zweite Oxidschicht
- 18: Kavität
- 18a: Seitenwände der Kavität
- 18b: Bodenwand der Kavität
- 18c: Deckwand der Kavität
- 19: Gräben
- 20: Stege, die die Gräben 19 unterbrechen
- 21: Zentral-Platte der Membrane
- 22: Bauteile zur Erfassung des mechanischen Stresses
- 23: Anschlüsse mit Anschlussleitungen
- 24: Oberfläche des Wafer-Paketes
- 25: Membrane geringerer Dicke
- 26: Negativer Anschluss der Wheatstone Brücke
- 27: Positiver Anschluss der Wheatstone Brücke
- 28: Erste Klemme zum Abgriff der Spannung an der Wheatstone Brücke
- 29: Untere p-Kanal MOS Diode der Referenzspannungsquelle für die Wheatstone Brücke
- 30: Obere p-Kanal MOS Diode der Referenzspannungsquelle für die Wheatstone Brücke
- 31: Erster p-Kanal MOS Transistor der Wheatstone Brücke
- 32: Zweiter p-Kanal MOS Transistor der Wheatstone Brücke
- 33: Dritter p-Kanal MOS Transistor der Wheatstone Brücke
- 34: Vierter p-Kanal MOS Transistor der Wheatstone Brücke
- 35: Referenzspannungsleitung
- 36: Zweite Klemme zum Abgriff der Spannung an der Wheatstone Brücke
- 37: n+ Channel-Stop Implantation
- 38: Gate-Anschluss Transistor 32 und 34 in niederohmigem Polysilizium
- 39: Gate-Anschluss Transistor 33 und 31 in niederohmigem Polysilizium
- 40: n- dotierete Fläche (nicht leitend)
- 41: Obere gegen mechanischen Stress empfindliche Struktur, beispielsweise eine Wheatstone-Brücke nach Fig. 12
- 42: Rechte gegen mechanischen Stress empfindliche Struktur, beispielsweise eine Wheatstone-Brücke nach Fig. 12
- 43: Untere gegen mechanischen Stress empfindliche Struktur, beispielsweise eine Wheatstone-Brücke nach Fig. 12
- 44: Erster Differenzverstärker p-Kanal-Transistor
- 45: Zweiter Differenzverstärker p-Kanal-Transistor
- 46: Dritter Differenzverstärker p-Kanal-Transistor
- 47: Vierter Differenzverstärker p-Kanal-Transistor
- 48: Referenzspannung für Transistoren 44,45,46,47
- 49: Stromquellenzuleitung für p-Kanal-Transistoren 44,45,46,47
- 50: Gemeinsamer Drain Kontakt der p-Kanal-Transistoren 44,45,46,47
- 51: Anschluss Transistor 46, Negativer Ausgangskonten des Differenzverstärkers
- 52: Anschluss Transistor 45, Positiver Ausgangsknoten des Differenzverstärkers
- 53: Anschluss Transistor 44, Negativer Ausgangskonten des Differenzverstärkers
- 54: Anschluss Transistor 47, Positiver Ausgangsknoten des Differenzverstärkers
- 55: Dritter p-Kanal Transistor für Referenzbrückenschaltung
- 56: Vierter p-Kanal Transistor für Referenzbrückenschaltung
- 57: Obere gegen mechanischen Stress empfindliche Struktur, beispielsweise eine Wheatstone-Brücke nach Fig. 12 als Referenzstruktur für 41 im Bereich frei von mechanischem Stress
- 58: Rechte gegen mechanischen Stress empfindliche Struktur, beispielsweise eine Wheatstone-Brücke nach Fig. 12 als Referenzstruktur für 42 im Bereich frei von mechanischem Stress
- 59: Untere gegen mechanischen Stress empfindliche Struktur, beispielsweise eine Wheatstone-Brücke nach Fig. 12 als Referenzstruktur für 43 im Bereich frei von mechanischem Stress
- 60: Linke gegen mechanischen stress empfindliche Struktur, beispielsweise eine Wheatstone-Brücke nach Fig. 12 als Referenzstruktur für 44 im Bereich frei von mechanischem Stress
- 61: Differenz-Verstärker: Stromspiegeltransistor korrespondierend zu Transitor 69
- 62: Differenz-Verstärker: Stromspiegeltransistor korrespondierend zu Transitor 70
- 63: Differenz-Verstärker: Stromspiegeltransistor korrespondierend zu Transitor 71
- 64: Differenz-Verstärker: Stromspiegeltransistor korrespondierend zu Transitor 72
- 65: Referenz-Verstärker: Erster Differenzverstärker p-Kanal-Transistor
- 66: Referenz-Verstärker: Zweiter Differenzverstärker p-Kanal-Transistor
- 67: Referenz-Verstärker: Dritter Differenzverstärker p-Kanal-Transistor
- 68: Referenz-Verstärker: Vierter Differenzverstärker p-Kanal-Transistor
- 69: Referenz-Verstärker: Stromspiegeltransistor korrespondieren zu Transitor 61
- 70: Referenz-Verstärker: Stromspiegeltransistor korrespondieren zu Transitor 62
- 71: Referenz-Verstärker: Stromspiegeltransistor korrespondieren zu Transitor 63
- 72: Referenz-Verstärker: Stromspiegeltransistor korrespondieren zu Transitor 64
- 73: Referenz-Verstärker: n Kanal Stromquellentransistor (Stromspiegel)
- 74: Differenz-Verstärker: n Kanal Stromquellentransistor (Stromspiegel)
- 75: Negativer Anschluss
- 76: Positiver Anschluss
- 77: Negatives Ausgangssignal
- 78: Positives Ausgangssignal
- 79: p+ Kontaktimplantation
- 80: p+ Kontaktimplantation
- 81: Poly Gate eines selbstjustierenden p-Kanal MOS Transistors
- 82: n+ Implantationsgeblet (Channel-Stopp)
- 83: n+ Implantationsgebiet (Channel-Stopp)
- 84: Zuleitung aus hochdotiertem Poly-Silizium
- 85: Erster p-Kanal MOS Transistor der Wheatstone Brücke
- 86: Zweiter p-Kanal MOS Transistor der Wheatstone Brücke
- 87: Dritter p-Kanal MOS Transistor der Wheatstone Brücke
- 88: Vierter p-Kanal MOS Transistor der Wheatstone Brücke
- 89: Linker Abgriff
- 90: Rechter Abgriff
- 91: Negativer Pol
- 92: Positiver Pol
- 93: Zweite Gruppe von Gräben zur Entkopplung der Membrane vom Die-Körper
- 94: Stege, die die Gruppe der zweiten Gräben 93 unterbrechen
- 95: Dritte Gruppe von Gräben zur weiteren Entkopplung der Membrane vom Die-Körper
- 96: Stege, die die dritte Gruppe von Gräben 95 unterbrechen
- 97: Boss mit Gitterstruktur (Tragwerk)
- 97a: Vertiefungen in der Gitterstruktur (Tragwerk)
- 97b: Versteifungsstreben der Gitterstruktur (Tragwerk)
- 98: Bohrung in die Kavität für Differenzdrucksensoren
- 99: Mechanischer Guard-Ring zur Verhinderung der Ausbreitung des durch das Bondsystem eingetragenen mechanischen Stresses
- 100: Linke gegen mechanischen stress empfindliche Struktur, beispielsweise eine Wheatstone-Brücke nach Fig. 12
- 101: Ein-Transistor-Element
- 102: Negativer Anschluss
- 103: Positiver Anschluss
- 104: Oberer Transistor links (p-Kanal)
- 105: Oberer Transistor rechts (p-Kanal)
- 106: Unterer Transistor links (p-Kanal)
- 107: Unterer Transistor rechts (p-Kanal)
- 108: Oberer Referenztransistor (p-Kanal)
- 109: Unterer Referenztransistor (p-Kanal)
- 110: Interne Referenzspannung
- 111: Erster Ausgang
- 112: Zweiter Ausgang
- 113: Parasitärer erster Transistor
- 114: Parasitärer zweiter Transistor
- 115: Gesamt-Transistor-Feldplatte
- 116: Hebellänge (hier das Beispiel Kavitätswand 3 zu Grabenwand)
- 117: Beispiel: Grabenwand
- 118: Höhe der oberen Struktur (hier beispielhafte Tiefe des Grabens 6)
- 119: Aufpunkt der oberen Struktur (hier beispielhaft Graben 6)
- 120: Höhe der unteren Struktur (hier beispielhafte Tiefe der Kavität 4)
- 121: Aufpunkt der unteren Struktur (Hier beispielhaft Kavität 4)

## Patentansprüche

1. Mikroelektromechanisches Halbleiterbauelement mit
- einem Halbleitersubstrat (16), in dem eine Kavität (18) ausgebildet ist, welche durch Seitenwände (18a) und durch eine Deck- sowie eine Bodenwand (18c,18b) begrenzt ist,
- wobei die Deck- oder Bodenwand (18c,18b) zwecks deren flexibler Anbindung an den Bereich des Halbleitersubstrats (16) längs der Seitenwände (18a) der Kavität (18) mit Gräben (19) versehen ist, zwischen denen mindestens ein Biegesteg (20) ausgebildet ist,
- wobei innerhalb mindestens eines dieser Biegestege (20) mindestens ein gegenüber mechanischen Spannungen empfindliches Messelement (22) ausgebildet ist,
**dadurch gekennzeichnet,**
- **dass** die Deck- oder Bodenwand (18c,18b) innerhalb ihres von den Gräben (19) umgebenen zentralen Bereichs (21) eine Vielzahl von die Masse des zentralen Bereichs (21) reduzierenden Vertiefungen (97a) und eine Vielzahl von die Vertiefungen (97a) allseitig voneinander trennenden Versteifungsstreben (97b) aufweist.

2. Mikroelektromechanisches Halbleiterbauelement nach Anspruch 1, **dadurch gekennzeichnet, dass** die Vertiefungen (97a) und die Versteifungsstreben (97b) jeweils längs sich insbesondere orthogonal zueinander erstreckender Linien angeordnet sind bzw. verlaufen.

3. Mikroelektromechanisches Halbleiterbauelement nach Anspruch 1 oder 2, **dadurch gekennzeichnet, dass** das mindestens eine gegenüber mechanischen Spannungen empfindliche Messelement (22) ein Widerstand, ein Transistor, insbesondere ein piezoresistives Bauelement, ist.

4. Mikroelektromechanisches Halbleiterbauelement nach Anspruch 3, **dadurch gekennzeichnet, dass** mehrere gegenüber mechanischen Spannungen empfindliche Messelemente (22) zu einer Messbrücke verschaltet sind.

5. Sensor, insbesondere Druck- oder Beschleunigungssensor, mit einem mikroelektromechanischen Halbleiterbauelement nach einem der vorhergehenden Ansprüche.

## Claims

1. A micro-electromechanical semiconductor component, comprising
- a semiconductor substrate (16) in which a cavity (18) is formed, which is delimited by lateral walls (18a) and by a top and a bottom wall (18c,18b),
- the top or bottom wall (18c,18b), for flexibly connecting it to the region of the semiconductor substrate (16), being provided with trenches (19) along the side walls (18a) of the cavity (18), at least one bending web (20) being formed between said trenches,
- at least one measuring element (22) that is sensitive to mechanical stresses being formed within at least one of said bending webs (20),
**characterized in**
- **that**, within its central region (21) surrounded by the trenches (19), the top or bottom wall (18c,18b) comprises a plurality of depressions (97a) reducing the mass of the central region (21) and a plurality of stiffening braces (97b) separating said depressions (97a) on all sides.

2. The micro-electromechanical semiconductor component according to claim 1, **characterized in that** the depressions (97a) and the stiffening braces (97b) each are arranged, and respectively extend, along lines oriented particularly orthogonally relative to each other.

3. The micro-electromechanical semiconductor component according to claim 1 or 2, **characterized in that** said at least one measuring element (22) sensitive to mechanical stresses is a resistor, a transistor, and particularly a piezoresistive component.

4. The micro-electromechanical semiconductor component according to claim 3, **characterized in that** a plurality of measuring elements (22) sensitive to mechanical stresses are connected to form a measurement bridge.

5. A sensor, particularly a pressure or acceleration sensor, comprising a micro-electromechanical semiconductor component according to any one of the preceding claims.

## Revendications

1. Composant semi-conducteur microélectromécanique, comprenant :
- un substrat semi-conducteur (16) dans lequel est formée une cavité (18) délimitée par des parois latérales (18a) et par une paroi de couverture et une paroi de fond (18c, 18b),
- la paroi de couverture ou la paroi de fond (18c, 18b) étant pourvue, à des fins de connexion flexible à la région du substrat semi-conducteur (16) le long des parois latérales (18a) de la cavité (18), de tranchées (19) entre lesquelles est formée au moins une nervure de flexion (20),
- au moins un élément de mesure (22) sensible aux contraintes mécaniques étant formé à l'intérieur d'au moins l'une de ces nervures de flexion (20),
**caractérisé en ce que**
- la paroi de couverture ou de fond (18c, 18b) présente, à l'intérieur de sa région centrale (21) entourée des tranchées (19), une pluralité de dépressions (97a) réduisant la masse de la région centrale (21) et une pluralité d'entretoises de renfort (97b) séparant les dépressions (97a) les unes des autres de tous côtés.

2. Composant semi-conducteur microélectromécanique selon la revendication 1, **caractérisé en ce que** les dépressions (97a) et les entretoises de renfort (97b) sont disposées ou s'étendent respectivement le long de lignes agencées en particulier de manière orthogonale entre elles.

3. Composant semi-conducteur microélectromécanique selon la revendication 1 ou 2, **caractérisé en ce que** ledit élément de mesure (22) sensible aux contraintes mécaniques, au moins au nombre de un, est une résistance, un transistor, en particulier un composant piézorésistif.

4. Composant semi-conducteur microélectromécanique selon la revendication 3, **caractérisé en ce que** plusieurs éléments de mesure (22) sensibles aux contraintes mécaniques sont reliés entre eux pour former un pont de mesure.

5. Capteur, en particulier capteur de pression ou d'accélération, comprenant un composant semi-conducteur microélectromécanique selon l'une des revendications précédentes.
